# EUROPEAN PATENT SPECIFICATION

(11) **EP 1 578 559 B1**
(45) Date of publication and mention of the grant of the patent: **18.03.2009**
(21) Application number: 03788702.3
(22) Date of filing: 17.09.2003
(51) Int. Cl.: B23K 35/02, B22F 7/06, B22F 1/00

(54) **BONDING METHOD**
VERFAHREN ZUM VERBINDEN
PROCEDE DE SOUDAGE

(30) Priority: 18.09.2002 JP 2002272364; 04.10.2002 JP 2002292868; 11.10.2002 JP 2002299520; 25.10.2002 JP 2002311732
(43) Date of publication of application: 28.09.2005
(73) Proprietor: EBARA CORPORATION, Ohta-ku, Tokyo 144-8510 (JP)
(72) Inventor: NAGASAWA, Hiroshi, Ohta-ku, Tokyo 144-8510 (JP); KAGOSHIMA, Kaori, Ohta-ku, Tokyo 144-8510 (JP); OGURE, Naoaki, Ohta-ku, Tokyo 144-8510 (JP); HIROSE, Masayoshi, Ohta-ku, Tokyo 144-8510 (JP); CHIKAMORI, Yusuke, Ohta-ku, Tokyo 144-8510 (JP)
(74) Representative: Wagner & Geyer
(86) International application number: PCT/JP2003/011797
(87) International publication number: WO 2004/026526

(56) References cited:
- EP-A- 0 960 675
- EP-A- 1 102 522
- EP-A- 1 107 298
- DE-A- 10 056 732
- US-A- 5 964 963
- US-B1- 6 372 077
- PATENT ABSTRACTS OF JAPAN vol. 2002, no. 09, 4 September 2002 (2002-09-04) & JP 2002 126869 A (HARIMA CHEM INC;ULVAC CORPORATE CENTER:KK), 8 May 2002 (2002-05-08)
- PATENT ABSTRACTS OF JAPAN vol. 017, no. 303 (C-1069), 10 June 1993 (1993-06-10) & JP 05 024942 A (HITACHI MAXELL LTD), 2 February 1993 (1993-02-02)

## Description

### Technical Field

The present invention relates to a bonding method which is useful for bonding a variety of parts together, in particular electronic parts, such as semiconductor devices, and mechanical parts, and more particularly to a bonding method which effects bonding between parts by using composite metallic nano-particles.

The present invention also relates to a method for bonding the electrodes of an electrode substrate particularly which, when mounting a semiconductor device (semiconductor package) on an interposer, a printed wiring substrate, etc., is used as the interposer, the printed wiring substrate, etc.,

The present invention also relates to the production of a bonded structure more particularly of a bonded structure comprising a chip, constituting an electronic part or a semiconductor device, and a substrate which are bonded together via contact bumps (contacts) provided on the surface of the chip and electrodes (contacts) on the substrate, a bonded structure comprising an electrical device or part and a conducting cable bonded together, and a bonded structure comprising members of a heat exchanger, an aircraft, etc., which members are bonded together.

Furthermore, the present application discloses a metallizing apparatus which can be used, for example, in a semiconductor device mounting process, for bonding leads and pins, which are for supply of driving power to a semiconductor device and input/output of electrical signals, or for bonding structural protrusions (bumps) on a semiconductor device to electrodes of a wiring substrate through metallization of a bonding material.

### Background Art

Soldering techniques using a solder alloy, such as face down bonding, have conventionally been used for electrical bonding e. g. between electrical terminals of an electronic device and circuit pattern terminals on a circuit substrate. In particular, to mount a semiconductor device, such as a chip, pellet or die, which is an uncovered active or passive device, called a bare device, on a circuit substrate while electrically bonding them together, a so-called face down method is becoming to be widely used. The method comprises forming solder bumps on electrode pads of a semiconductor device in advance, setting the solder bumps facedown on terminal electrodes of a circuit substrate, and heating the solder bumps at a high temperature to meld-bond the electrode pads of the semiconductor device to the terminal electrodes of the circuit substrate. The solder bumps are generally formed by plating or vapor deposition using a resist on a three-layer thin metal film (under bump metals) comprising, for example, Cr (chromium), Cu (copper) and Au (gold). This mounting method can provide the bonded structure with high mechanical strength and can effect the electrical bondings between the electrodes of a semiconductor device and the terminal electrodes of a circuit substrate all at once. The face down bonding method is therefore regarded as an effective semiconductor device mounting method.

Besides the face down bonding method, reflow soldering, which uses a solder paste containing a eutectic tin-lead alloy, is also widely employed for bonding between metals, e.g. for mounting an electronic part to a printed wiring substrate. The reflow soldering method comprises bringing a solder paste into contact with the surface of a metal as a bonding object, and heating and melting the solder paste. According to this method, a partial diffusion of metal occurs between the metal surface to be bonded and the molten solder, and therefore an alloy or an inter-metallic compound is formed at the interface upon cooling, whereby physical and electrical bonding is effected. The eutectic tin-lead alloy, which has been commonly used, has the advantages that it has a low melting point and that it is unlikely to cause erosion of the metal surface to be bonded. Further, bonding by brazing, including soldering, is commonly used also in assembling mechanical parts into a structure.

In recent years, strict restrictions have been imposed on the use of lead from the viewpoint of global environmental conservation. In order to solve the problem of outflow of lead into the environment upon disposal of used electric appliances and the problem of contamination of the working environment by evaporation of lead and scattering of lead oxide which inevitably occur upon melting of a tin-lead soldering material in a soldering process, development of a soldering or brazing method, which uses a bonding material not containing lead, is in progress. As a result, as a substitute for a eutectic solder having a melting point of about 180°C, an Sn-Ag solder (melting point: about 250°C) or the like has been put into practical use.

In bonding of parts of e.g. a heat exchanger or an aircraft, brazing is commonly employed. A brazing process involves heating of a metal material (brazing material) to a temperature equal to or higher than its melting point, so that the temperature of the bonding portion upon bonding is as high as 450 to 1000°C. Exposure of parts to such a high temperature as the maximum 1000°C generally causes a broad range of thermal deformation and a large thermal stress/distortion of the parts. A strong demand therefore exists for development of a bonding method that can securely bond the above parts, which parts require precision in the shape and size, at a relatively low temperature without entailing the problems such as thermal deformation.

A bonding method has been proposed in which a ball, which is formed from a metal paste containing ultrafine metal particles, is used in place of the above-described solder bump (see Japanese Patent Laid-Open Publication No. 9-326416). The ultrafine metal particles used in the method are considered to be ultrafine particles composed solely of metal which are produced, for example, by a method comprising evaporating a metal in vacuum in the presence of a small amount of gas to coagulate ultrafine particles consisting solely of metal from the vapor phase. Such ultrafine metal particles may be problematic in their stability, physical properties and cost.

In recent years, as electronic products are becoming smaller, there is an increasing demand for high integration of semiconductor packages. Also in the mounting technology of fixing a semiconductor package to an interposer or a printed wiring substrate for mutual connection of the respective current flow routes, a highly-integrated and high-density mounting method has been desired.

Micro soldering is well known as a method for bonding leads disposed linearly around a semiconductor package to predetermined electrodes provided in a printed circuit substrate by soldering. When providing leads linearly around a semiconductor package, the number of leads is limited. For example, in the case of QFP (Quad Flat Package) that is frequently used as a surface mounting-type semiconductor package, the minimum limit value is regarded as 0.3 mm (see Kobayashi et al., Suiyo-Kai Bulletin, 23, Feb. 2000, P. 123). The number of providable leads is thus restricted.

On the other hand, a so-called BGA (Ball Grid Array) method, which uses solder balls as contact terminals (electrodes) arranged in a lattice form on the entire back surface of a semiconductor package, has attracted attention since the late '90s and has been increasingly used practically. A semiconductor package of the BGA type (BGA package), with the provision of electrodes on the entire back surface, can have a remarkably larger number of electrodes per unit area as compared to a QFP package, enabling a higher-density and smaller-area mounting.

The minimum spacing of solder balls of a BGA package is regarded as 0.5 mm (see Matsuura et al., Hitachi Densen, No. 21, Jan. 2002, P. 53). The minimum value is considered to be determined in view of the flattening phenomenon of solder balls that occurs due to surface tension and gravity acting on a molten solder material. Though a smaller diameter of solder ball and a smaller spacing (pitch) between solder balls are favorable for high-density mounting, narrowing of the solder ball pitch can incur problems due to the material characteristics of solder.

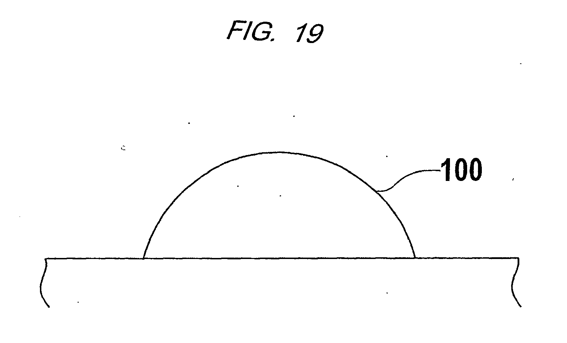

FIG. 19 shows an observation of flattening phenomenon of a solder ball (decrease in the height and increase in the diameter in a direction perpendicular to the height) 100 upon melting/liquefaction of the solder ball (see T. Osawa, "Story of Soldering", Japanese Standards Association, 2001, P. 105). Taking the solder ball flattening phenomenon into consideration, the solder ball pitch of BGA package is determined to be 0.5 mm at the minimum.

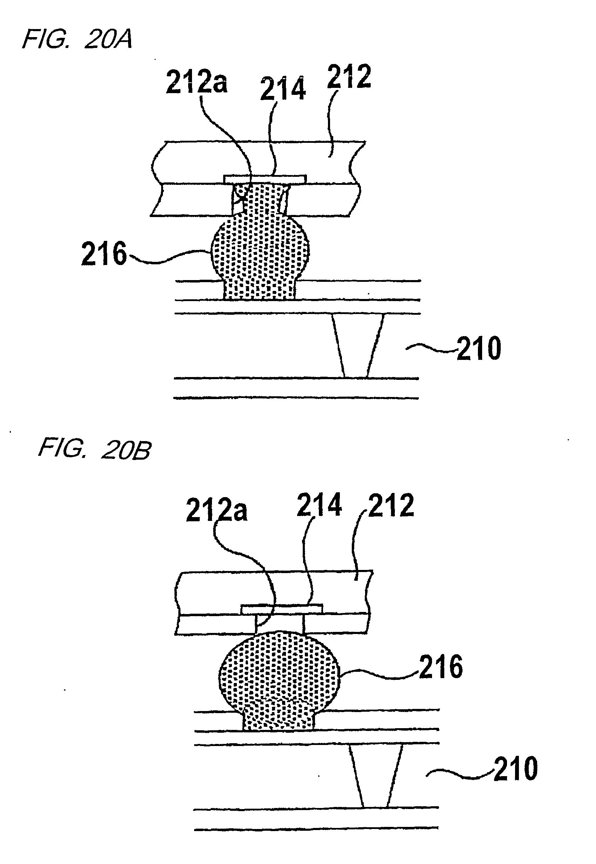

Further, with the narrowing of via hole diameter and solder ball diameter on the BGA package side, the reliability of solder ball bonding could be lost. FIGS. 20A and 20B illustrate typical problems in solder ball bonding due to the narrowing of solder ball pitch. FIG. 20A illustrates a solder twisting phenomenon: a solder ball 216, connecting a wiring substrate 210 to an electrode 214 of a BGA package 212, migrates toward the wiring substrate 210, whereby the solder ball 216 positioned in a via hole 212a of the BGA package 214 becomes thinner. FIG. 20B illustrates a solder falling phenomenon: the solder ball 216 falls toward the wiring substrate 210, whereby the solder ball 216 comes to connect only with the wiring substrate 210, that is, connection between the wiring substrate 210 and the BGA package becomes broken.

The problems illustrated in FIGS. 20A and 20B are mainly due to narrowing of the pitch and diameter of the solder ball to a level lower than the minimum limit. The phenomena are considered inevitable in the micro soldering method which effects bonding through melting/liquefaction of a solder alloy by heating and the subsequent solidification of the solder alloy by cooling.

As described above, with respect to BGA packages, there is a necessary restriction on the narrowing of the pitch and diameter of solder balls.

As described previously, micro soldering, which uses a solder composed of tin and lead, is widely used for electrical bonding e.g. between electrical contact bumps arranged on the surface of a chip, constituting an electronic part or a semiconductor device, and electrodes provided on a substrate at positions corresponding to the bumps. This is because such a bonding method using a solder, in general, can secure a bonding strength of about 39.2 MPa and enable the solder bulk to have an electric resistance of about 17 µΩcm and a melting point of about 180°C, and can obtain well-balanced bonding properties with ease.

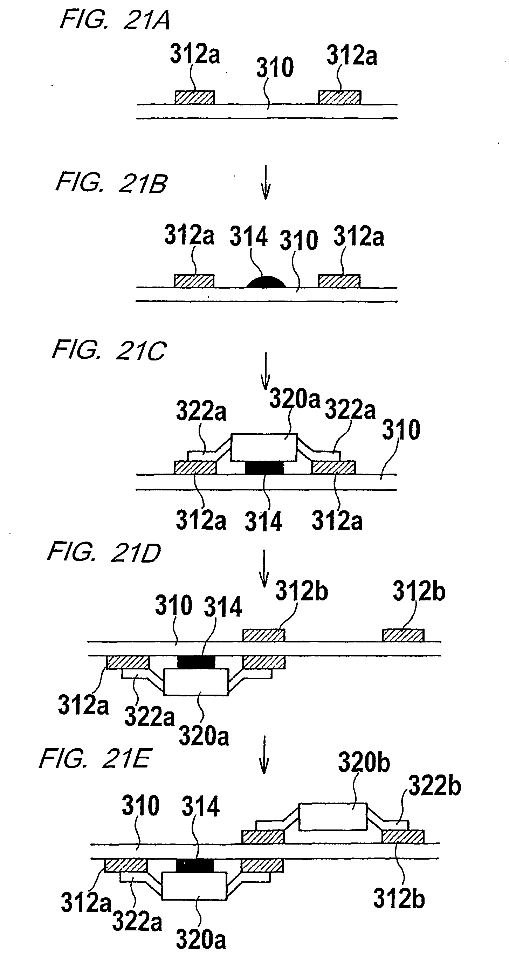

FIGS. 21A through 21E illustrate an example of a surface mounting process of mounting IC packages of the QFP (Quad Flat Package) type on both sides of a printed wiring substrate by conventional reflow soldering using such a solder. First, as showninFIG.21A, a solder paste 312 a is printed onto predetermined portions of the front surface (upper surface) of the printed wiring substrate 310. Further, as shown in FIG. 21B, an adhesive 314 is applied onto predetermined portions between the solder pastes 312a. Thereafter, as shown in FIG. 21C, while each lead 322a is brought into pressure contact with each solder paste 312a, an IC package 320a is attached to the surface of the printed wiring substrate 310 via the adhesive 314, and the adhesive 314 is then dried and hardened.

Next, as shown in FIG. 21D, after reversing the printed wiring substrate 310, a solder paste 312b is printed onto predetermined portions of the back surface (upper surface) of the printed wiring substrate 310. Thereafter, as shown in FIG. 21E, an IC package 320b is attached to the back surface of the printed wiring substrate 310 by bringing each lead 322b into pressure contact with each solder paste 312b. The solder pastes 312a, 312b are then heated e.g. at about 300°C to melt the solder pastes 312a, followed by cooling for solidification.

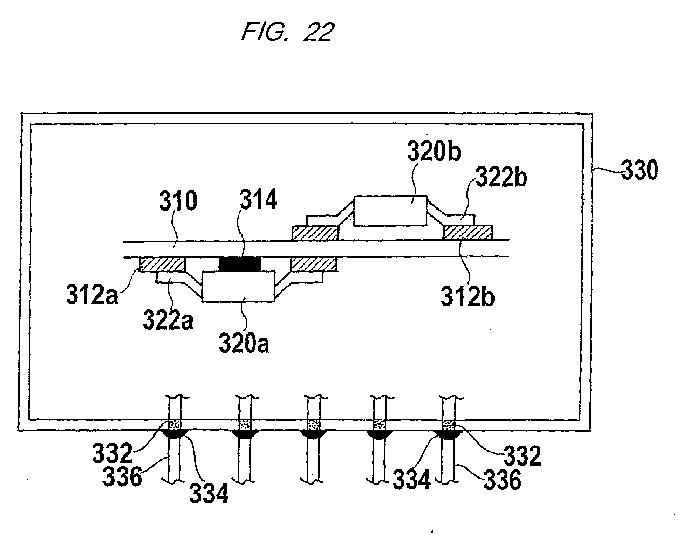

As shown in FIG. 22, when the printed wiring substrate 310, to which the IC packages 320a, 320b are thus mounted, is housed in a outer casing 330, leads 336 are bonded via solders 334 to electrodes 332 provided in the outer casing 330.

When bonding the leads 336 to the electrodes 332 of the outer casing 330, the bonding portions 312a, 312b between the printed wiring substrate 310 and the IC packages 320a, 320b must be prevented from re-melting by the heating and temperature rise upon the later bonding and thereby damaging electrical constant. Accordingly, it is generally practiced to use a high-temperature solder (melting point: about 300°C) containing 95 % by weight of Pb for bonding between the printed wiring substrate 310 and the IC packages 320a, 320b, and use an ordinary low-temperature solder (melting point: about 183°C) for bonding of the leads 336 to the electrodes 332 of the outer casing 330. By thus using the two types of solders having different melting points, the internal electrical contact of the outer casing 330 can be prevented from being damaged by the re-melting when leads 336 is bonded to the outer casing 330.

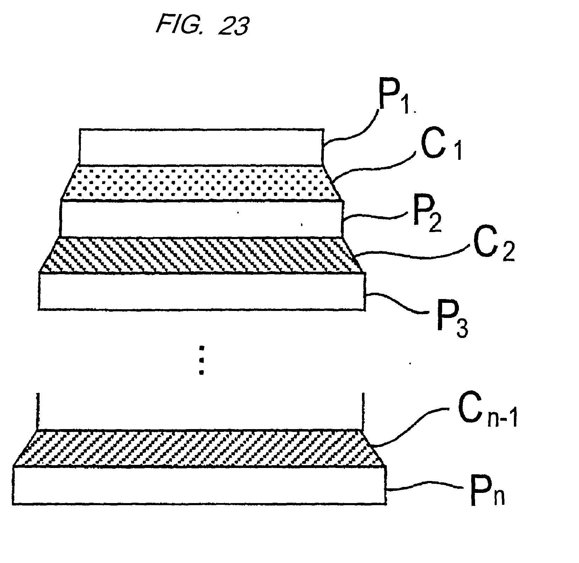

When a product is manufactured through bondings of necessary parts, a so-called stepwise soldering is carried out. In the case of stepwise soldering, a high-temperature solder containing Pb is used at least in the first-step solder bonding. As shown in FIG. 23, a stepwise soldering process generally comprises stepwise lamination of a plurality of parts P₁, P₂... via solder bonding layers C₁, C₂... to provide a product of an integrated structure of "n" pieces of parts P₁-Pₙ. In this process, it is necessary to avoid re-melting of a bonding layer upon a later step of bonding. It is therefore required to use a solder material having the highest melting point for the formation of the first bonding layer C₁, and use solder materials having decreasingly lower melting points for the subsequent bondings. With respect to semiconductor devices, the use of a high-temperature solder is requisite especially for a so-called high-power module of high current density.

As described previously, the use of lead (Pb) has been strictly restricted by laws and regulation from the viewpoint of environmental conservation. Also with respect to solder materials for bonding, which usually contain not less than 40% of lead, they are forced to be replaced with solder materials containing no lead. As a replacement for an ordinary Sn(60%)-Pb(40%) solder, a Sn-Ag solder and a Sn-Ag-Cu solder have been developed and they are becoming to be widely used practically. With respect to a high-temperature solder for use in the earlier step of stepwise soldering, however, a Sn(5%)-Pb(95%) solder is a sole practical material. There is no prospect of development of a lead-free solder to be replaced for such solder yet. Further, the conventional high-temperature solder is used also when a semiconductor package is used in a high-temperature atmosphere (for example, near a vehicle engine). A substitute solder material is therefore demanded also for such application.

As described hereinabove, there is a limit to higher integration and higher densification in the conventional semiconductor device mounting technology. Further, there is a strong demand for a technology that enables the use of a lead-free bonding material that can replace a high-temperature solder, and carry out, for example, the first-step bonding of a stepwise bonding process

EP 1 107 298 A discloses a solution containing a metal component comprising composite ultrafine metal particles each having a core substantially made of a metal component and a covering layer made of an organic compound chemically bonded to the core. The core has an average diameter ranging from 1 to 10 nm. The composite ultrafine metal particles are uniformly dispersed in a solvent.

JP 2002-126869 A discloses a brazing material comprising a liquid dispersion in an organic solvent of ultra-fine metal particle having a diameter of 100 nm or less. More particularly, in order to avoid conventional Sn-Pb soldering, i. e. a soldering method using a soldering material not containing lead, this document discloses that a brazing material, a metal whose mean particle diameter is 100 nm or less, e.g. a noble metal or a hyper fine grain of copper is used, the surface thereof is covered with an amine compound having an end amine group, an acid anhydride, etc., capable of reacting with the amine compound having the end amine group when heated is added to the dispersion liquid in an appropriate quantity as a metal colloid dispersion liquid dispersed evenly in an organic solvent. The material is heated up to the same degree of temperature as the soldering temperature, and by making mutual dispersion fusion in the contact boundary face between the bulk metal surface and the hyper fine grain, and fusion among the hyper fine grains, the jointed layer is formed.

EP 1 102 522 A discloses a substrate coated with a conductive layer, which comprises a conductive layer of bonded ultrafine metal particles formed on the top surface thereof. The ultrafine metal particles have a diameter of 1-20 nm, and the substrate is of a flexible high polymer material. Since the conductive layer is formed by bonded layer of the ultrafine metal particles, an extremely thin layer having high conductivity can be formed. This structure enables the formation of a flexible printed circuit board with high-density interconnects or a transparent conductive film provided with both transparency and conductivity. Conventional vacuum equipments and complicated processes are not necessary for forming the conductive layer on the substrate

Finally, US 6,372,077 A discloses a method of making isolated particles including the step of at least substantially encapsulating particles present in a highly dispersed colloidal suspension with an encapsulant material, such that the encapsulated particles remain independent and discrete upon separation from the suspension. Also, independent and discrete particles at least substantially encapsulated with the encapsulant material are disclosed.

### Disclosure of Invention

The present invention has been made in view of the above situation in the background art. It is therefore a first object of the present invention to provide a bonding method that enables lead-free bonding that can replace high-temperature soldering.

It is a second object of the present invention to provide a method for bonding the electrodes of the electrode substrate which can respond to the demand for higher integration and higher densification e.g. in the semiconductor device mounting technology and which can carry out, e.g: the first-step bonding of a stepwise bonding process by using a bonding material not containing lead.

In order to achieve the above objects, the present invention provides a bonding method as set forth in claim 1. Preferred embodiments of the present invention may be gathered from the dependent claims..

It is known that the melting initiation temperature of a metal particle decreases with a decrease in the particle size (diameter) when the particle is fine. The relation holds for a particle size of less than 100 nm, and the degree of the temperature decrease is large when the particle size is less than 20 nm. Particles of some metals melt and bond together at a considerably lower temperature than the melting point of the metal in a bulk state when the particle size is less than 10 nm.

Further, in advance of melting, a sintering phenomenon of metal particles occurs, and the sintering initiation temperature is also considerably lower than the melting point of the bulk metal. Bonding between the metal particles occurs through low-temperature sintering. In this regard, there is a published data showing that in the case of ultrafine Ag particles having an average particle diameter of 20 nm, sintering starts at a low temperature of 60-80°C (see Sato, "Production and Application of Ultrafine Metal Particles", Proceedings of the Japan Institute of Metals Symposium, 1975, P. 26).

Composite metallic nano-particles having such a structure that the surface of a metal core is combined and coated with an organic material, because of the organic material functioning as a protective coating for protection of the metal core, can be dispersed uniformly in an organic solvent and are highly stable as discrete particles. Accordingly, it is possible to provide a liquid bonding material containing the main bonding material (composite metallic nano-particles), which can be sintered and melt-bonded at a low temperature, uniformly dispersed in an organic solvent.

In the case of clustered silver nano-particles having a particle size of about 5 nm, the apparent melt bonding initiation temperature is about 210°C, and the silver nano-particles can be melt-bonded or sintered by heating the nano-particles at a temperature equal to or higher than the melt bonding initiation temperature.

On the other hand, an adhesive containing ultrafine particles having a particle diameter of not more than 20 nm in admixture with other materials and a bonding method using the adhesive have been proposed (see e.g. Japanese Patent Laid-Open Publication No. 5-54942). In this method, the ultrafine particles are present as a simple metal in a medium, that is, unlike the bonding material of the present invention, the ultrafine particles do not have a coating of an organic material. According to experiments by the present inventors, such bare ultrafine metal particles easily agglomerate into coarse particles, whereby the dispersion state is likely to become uneven. When the ultrafine particles agglomerate and the dispersed phase becomes composed mainly of large particles, since the melting initiation temperature and the sintering temperature of the large particles are higher than those of the ultrafine particles, it is difficult or impossible to carry out low-temperature bonding with such bonding material (adhesive).

The bonding material disclosed herein contains the above-described composite metallic nano-particles as a base material, and optionally contains as an aggregate metallic, organic or inorganic particles that are larger than nano-paticles. In the case of adding the aggregate, the presence of the larger particles than nano-particles is similar to the above-described case of the presence of agglomerated coarse particles. According to the bonding material of the present disclosure, however, the composite metallic nano-particles as a main bonding material do not agglomerate, and still remain as they are, and therefore low-temperature sintering still occurs. This is clearly distinct from the above-described case where the ultrafine particles agglomerate into large particles, leaving almost no nano-particles, and therefore low-temperature sintering does not occur.

According to the present invention, unlike the case of dispersing ultrafine metallic particles as a simple metal in a medium, composite metallic nano-particles, whose metal cores are combined and coated with an organic material, are dispersed in a medium. Accordingly, the nano-particles do not agglomerate into coarse particles and hold a uniform dispersion. The bonding material of the present disclosure can thus obviate the above problems.

On the other hand, when the organic material contains an element other than C, H and O, such as nitrogen (N), sulfur (S), etc., there is a case where the N or S component in the organic material remains in the sintered metal even after carrying out a process of decomposing and evaporating the organic material by heating upon bonding. The presence of such an element can adversely affect the electric conductivity of the bonding layer. A lowering of the electric conductivity would be a serious problem especially with a high-density mounting part of high operating current density.

By using composite metallic nano-particles not containing N or S, it becomes possible to prevent the N or S component from remaining in the bonding portion after the decomposition and evaporation of the organic material, thereby preventing lowering of the electric conductivity in the bonded product of high-density mounting parts.

According to a preferred embodiment of the present invention, by adjusting the dispersing conditions when dispersing the composite metallic nano-particles with the average particle diameter of the metal core of not more than 100 nm in an organic solvent, the bonding material may be prepared in the form of a liquid, slurry, paste or cream, in a solid form, or in a semisolid or jellylike form.

In the case of a liquid form, it is practically preferred that the weight ratio of the metal portion to the total liquid be in the range of 1 to 30%. Specific examples of the organic solvent include toluene, xylene, hexane, octane, decane, cyclohexane, pinene, limonene, and ethylene glycol. In the case of a slurry, paste or cream form, it is practically preferred that the weight ratio of the metal portion to the total fluid be in the range of 15 to 90%. Further, in the case of a solid form or a semi solid of jellylike form, it is practically preferred that the weight ratio of the metal portion to the total bonding material be in the range of 20 to 95%.

According to a preferred embodiment of the present invention, in addition to the composite metallic nano-particles, an aggregate having an average particle size of not more than 100 µm is mixed in the bonding material.

The addition of an aggregate having an average particle size of not more than 100 µm can impart various properties, which are absent when the composite metallic nano-particles alone are used, to the bonding material.

The aggregate may be of a metallic material, a plastic material, or an inorganic material, and may be used either singly or in combination. The particle size of the aggregate is preferably 0.1 to 1.0 µm.

The inorganic material includes ceramics, carbon, diamond, glass, etc.

In the case of metal material, the aggregate maybe a material of e. g. Al, Cu, Mg. Fe, Ni, Au, Ag, Pd or Pt, or a material composed of a plurality of these elements. The use as an aggregate of such a metal material having various properties can secure stable strength, tenacity, etc. of the bonding portion or improve the electric conductivity of the bonding portion.

The use of a plastic material as an aggregate can lighten the bonding portion. A heat-resistant plastic material, such as polyimide, polyaramid or polyetheretherketone material, is less likely to be denatured or deteriorated when it is exposed to the heating temperature upon bonding, and therefore can be advantageously used.

The use as an aggregate of an inorganic material other than metal and plastic materials, which may be any one of those as exemplified above, can simultaneously achieve lightening and reinforcement of the bonding portion.

As the aggregate, only one of the above-described various types of materials may be used singly. Alternatively, it is possible to select a plurality of types of materials and use the materials in combination.

Table 1 below shows the content of the aggregate in the total bonding material. In the case of metal aggregate, the content refers to the total metal content, i.e. the content of the additive and the metal core portion of the composite metallic nano-particles.

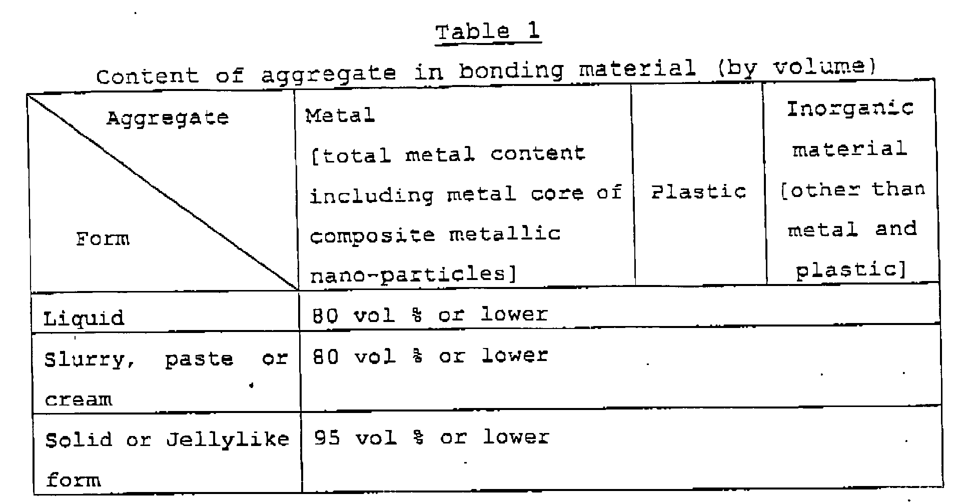

Table 1 specifically shows the upper limits of the different types of aggregates in the various forms of bonding materials.

When the content of the aggregate exceeds the respective upper limits, the fluidity of the bonding material upon heating significantly lowers. When filling a minute space with such a bonding material having a low fluidity, an incomplete filling is likely to occur. By making the volumetric content of the aggregate in the total bonding material within the ranges specified in Table 1, it becomes possible to provide a bonding material having a desired fluidity in which the main bonding material (composite metallic nano-particles) that can be sintered andmelt-bonded at a low temperature and the aggregate are blended at a proper proportion.

The metal core portion of the composite metallic nano-particles may be composed of either one of Au, Ag, Pd, Pt, Cu, and Ni, or a combination of two or more thereof.

The properties of the composite metallic nano-particles, after the change in the form, turn to the same properties as the metal in a bulk state. In particular, the melting initiation temperature increases to the melting point of the metal in a bulk state. For example, in the case of silver nano-particles having a metal core size of 5 nm, the melt bonding initiation temperature (melting point) is about 210°C. On the other hand, the melting point of the bulkmetal is 961.93°C. Once the metallic nano-particles bond together, the bonded body does not re-melt unless it is heated to 961.93°C or higher. The bonding material thus offers an ideal bonding material for repeated bondings required of high-temperature soldering.

With conventional bonding methods, bonding is sometimes difficult or impossible for some types of materials. On the other hand, the bonding method of the present invention can basically effect bonding between all types of materials, i.e. metals, plastics and ceramics, including bonding between materials of the same type and bonding between materials of different types.

The bonding material may be allowed to be present between and in contact with predetermined portions of parts to be bonded by using any application method such as spraying, coating, dipping, spin coating, printing, dispensing, or insertion.

The application of energy is preferably carried out by heating or by pressurization, or by heating and pressurisation. The heating may be carried out by means of, for example, combustion heat, electric heat, heated fluid, energetic beam irradiation, passing of electricity between parts, induction heating, dielectric heating, or plasma. The bonding object is heated to a temperature not higher than 400°C.

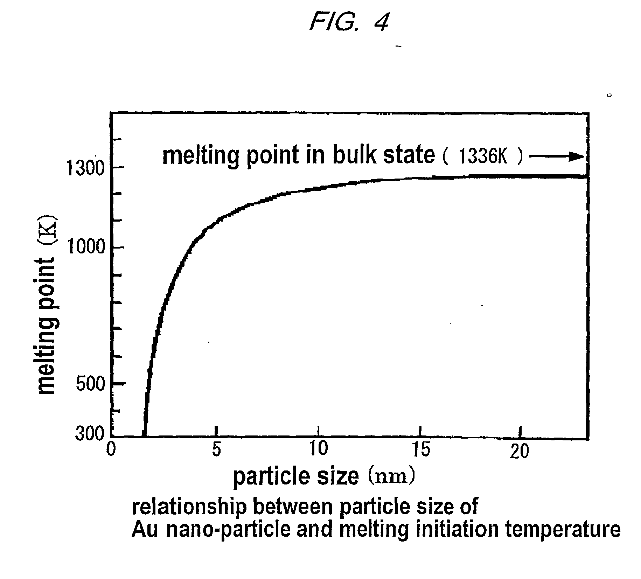

An explanation will now be given of the relationship between the particle size of noble metallic nano-particles, which are commonly used practically, and the melting initiation temperature. FIG. 4 illustrates the relationship between the particle size of Au nano-particle and the melting initiation temperature (see C. R. M. Wronski, Brit. J. Appl. Phys., 18 (1967), P. 1731). As apparent from FIG. 4, a drastic lowering of melting initiation temperature appears when the particle size decreases to smaller than 10 nm. When the particle size is 2 nm, for example, the melting initiation temperature is as low as about 120°C.

Heating to a higher temperature is preferred for bonding because the atomic diffusion/sintering is more vigorous. To avoid deterioration of a semiconductor device at high temperatures, heating to a temperature exceeding 400°C is not permissible.

For these reasons, the highest heating temperature for bonding according to the present invention is restricted to 400°C.

The bonding may preferably be carried out in the air, in a dry air, in an oxidizing gas atmosphere, in an inert gas atmosphere, in vacuum, or in an atmosphere with reduced mist. These atmospheres can be utilized in order to avoid contamination, denaturing, deterioration, etc. of the bonding surface and carry out a reliable bonding with a clean surface.

In advantage of the bonding, the bonding surface of the part to be bonded may be subjected to a surface treatment so as to properly adjust the roughness, activity, cleanness, etc. of the surface, thereby improving the reliability of bonding. Usable surface treatments may include at least one of cleaning, pure water cleaning, chemical etching, corona discharge treatment, flame treatment, plasma treatment, ultraviolet-ray irradiation, laser irradiation, ion beam etching, sputter etching, anodic oxidation, mechanical grinding, fluid grinding, and blasting.

It is possible to further bond other part(s) to the bonded structure, in which the form of the composite metallic nano-particles contained in the bonding material has been changed, by using the same bonding material.

In the case of the conventional soldering or brazing, the bonding temperature is equal to the melting point of a solder or a brazing material. Accordingly, when a point once bonded is heated again to the bonding temperature or higher, the point melts and fluidifies. In clear contrast thereto, in the case of the present method which utilizes the phenomenon of depression of melting initiation temperature and sintering temperature due to the metallic nano-particles, a previously-bonded portion does not re-melt by the heat applied upon a later bonding. For example, in the case of composite silver nano-particles having a particle diameter of 5 nm, once the nano-particles are heated at 210°C or higher and bond together, the melting point of the bonding portion has increased to the melting point of silver metal in a bulk state, i.e. 961.93°C. Accordingly, the bonded portion will not re-melt unless it reaches 961.93°C by re-heating. The present method thus enables a one-mode bonding. This is advantageous over the conventional brazing which must employ different brazing materials with different melting points to carry out a stepwise brazing process using the reflow method that involves heating of the entire parts.

According to the method of the present invention, repeated bondings can be carried out by using the same bonding material. It is of course possible to use the present method to bond a part to a bonded part which has been bonded by the present method. It is also possible to bond bonded parts together. Thus, the present method makes it possible to carry out repeated bondings using the reflow method to bond bonded parts, which have been bonded using the ref low method, to each other. Accordingly, the method of the present invention can advantageously be used especially in mounting of electronic parts.

It is also possible to allow the bonding material, containing as a main bonding material composite metallic nano-particles with the metal core portion having an average particle diameter of not more than 100 nm, to be prevent between and in contact with predetermined portions of structures, each structure being composed of at least two independent parts, and change the form of the composite metallic nano-particles contained in the bonding material, thereby bonding the structures together.

As in well known, when particles having a small diameter are brought into contact with one another and heated to a certain temperature or higher, there generally occurs a sintering phenomenon, i.e., the particles become more strongly bonded to one another and finally come to an integrated structure (see "Metallurgy for a Million People", edited by S. Sakui, Agne, Sep. 1989, P. 272-277). As the diameter of the particles in contact with one another decreases, the number of contact points per unit volume of the system increases and the sintering initiation temperature decreases. Thus, the smaller the particle diameter is, the more easily occurs the sintering,

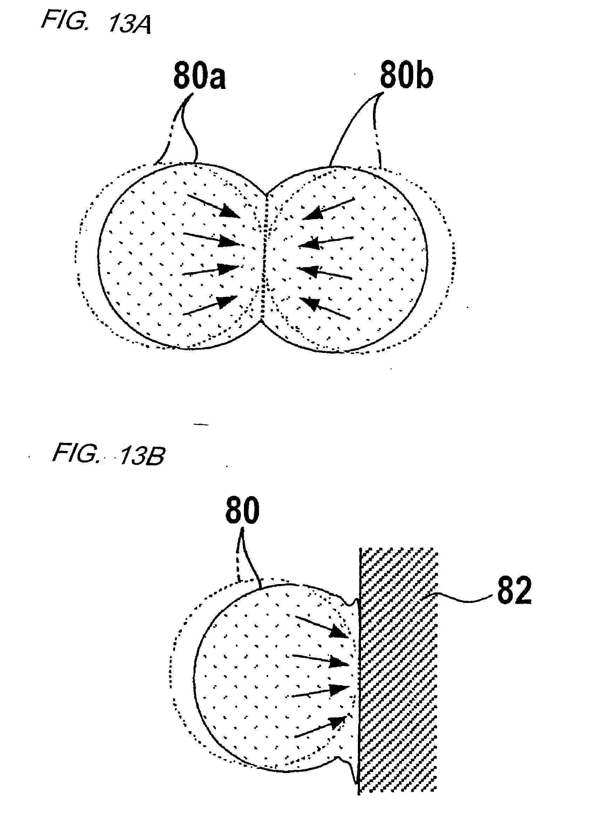

FIG. 13A illustrates the process of bonding by sintering between small particles 80a and 80b, and FIG. 13B illustrates the process of bonding by sintering between a small particle 80 and a large object 82 (see "Metallurgy for a Million People", edited by S. Sakui, Agne, Sep. 1989, P. 272-277). Thus, in FIGS. 13A and 13B, the broken lines show the forms of the particles before sintering, and the solid lines show the forms of the particles after sintering. It has been confirmed that diffusion/migration of atoms constituting a small particle occurs by thermal activation of the atoms at the surface and in the interior of the particle, and the atoms gradually migrate toward the contact portion, whereby the bonding progresses.

The power source that causes the diffusion of atoms is the surface tension of a particle, which acts.strongly especially in the depres sed area around the contact portion between particles or between the particle and the object, and forces the atoms to migrate toward the contact portion. The surface tension is generated by a surface energy which is stored in the surface of a particle. The total surface energy in the system is proportional to the total sum of the respective surface areas of particles. Accordingly, the smaller the particle diameter is, the larger is the total surface energy, that is, sintering occurs more easily (see "Metallurgy for a Million People", edited by S. Sakui, Agne, Sep. 1989, P. 272-277).

The average particle diameter of the metal cores of the composite metallic nano-particles according to the present invention is generally not more than 100 nm, preferably not more than 20 nm, more preferably not more than 5 nm. Though the minimum value of the average core diameter is not particularly limited insofar as its production is possible, it is generally about 0.5 nm, or about 1.0 nm. Table 2 below shows temperatures at which metallic nano-particles (Fe, Ag, Ni, Cu) having a diameter of 50 nm or less start sintering (see Ichinose et al., "Approach to Ultrafine Particles Technology", Ohmsha, 1988, P. 26-29)

**Table 2**

| Metal | Diameter (nm) | Sintering initiation temp. (°C) |
|---|---|---|
| Fe | 50 | 300-400 |
| Ag | 20 | 60-80 |
| Ni | 20 | -200 |
| Cu | | 200 |

As shown in Table 2, when silver nano-particles having a diameter of 20 nm are used, sintering occurs at a temperature of 60 to 80°C, i.e. a temperature near room temperature (low-temperature sintering). This constitutes the essence of the bonding mechanism according to the present invention. In principle, therefore, it is possible to carry out a bonding operation at a much lower temperature as compared to the conventional soldering by selecting the particle size. Further, by selecting the temperature and other conditions, the bonding according to the present invention can be applied to bonding objects of all types of materials, including metals, plastics, ceramics, etc.

The composite metallic nano-particles, which are used as a main bonding material, have such a structure that a small metal core is combined and coated with an organic material. Such composite metallic nano-particles can be produced easily at a low cost, for example by subjecting a metal salt and an organic material to heat reduction. The composite metallic nano-particles with the metal' cores combined and coated with the organic material, as compared to simple metal particles, have the great advantage that they do not agglomerate into coarse particles even when they are collected for storage.

As described above, particles can sinter more easily as a particle size is smaller. It is therefore very important and requisite for particles to hold a uniform dispersion in a medium without agglomeration. The composite metallic nano-particles with the metal cores combined and coated with an organic material, when dispersed in an appropriate solvent, do not agglomerate into coarse particles, and thus can be advantageously used as a main bonding material.

As described hereinabove, the bonding mechanism according to the present invention is a low-temperature sintering. Thus, unlike the conventional solder bonding, the bonding material in the present invention does not undergo the process of melting → liquefaction → solidification.

When a solid (solder) melts and liquefies, due to the relationship between the surface tension of the liquid and gravity, problematic phenomena, such as solder twisting and solder falling as shown in FIGS. 20A and 20B, may occur. Further, such a solder bonding must be confronted with the limit value 0.5 mm of the electrode pitch narrowing due to the flattening phenomenon of a solder ball in the liquid state. On the other hand, the bonding according to the present invention does not utilize such a melting/liquefaction phenomenon, but utilizes a sintering phenomenon that proceeds substantially in a solid phase, and therefore is freed from the problems shown in FIGS. 20A and 20B and from the limit of the electrode pitch narrowing due to the solder ball flattening. This is because, as compared to the case of melting and liquefaction according to the conventional soldering, the scale of change in the shape and volume of the metal particles upon sintering is extremely small according to the present invention. Thus, according to the present invention, the electrode pitch can be narrowed to a much smaller value than that possible with the solder bonding.

According to the present invention, it becomes possible to effect bonding at a very low temperature which is close to room temperature. Further, once bonding is completed, the bonding portion does not re-melt unless it is heated to the melting point of the metal in a bulk state. For example, when bonding with silver nano-particles is completed, it is necessary to heat the bonding portion to at least 961.93°C in order to melt the bonding portion. Thus, a bonding portion is kept bonded unless it is heated to a much higher temperature than the heating temperature upon bonding. Accordingly, a stepwise bonding process as shown in FIG. 23 can be carried out without the necessity of sequentially using solderingmaterials with high to low varying melting points. Thus, even when manufacturing a product through stepwise bondings of a plurality of parts, bonding/manufacturing can be carried out by using the same bonding material without limitation on the number of parts.

The above-described substrate is preferably used for mounting of a semiconductor device. Examples of the substrate include an interposer and a printed wiring substrate for surface mounting of a semiconductor package.

In many cases, a bonding portion by welding or brazing has a so-called solidified structure which has been formed through melting of a metal and the following solidification. According to the bonded structure of the present invention, on the other hand, the bonding portion of the bonded structure has a sintered metal structure which has been formed without undergoing melting/liquefaction of the bonding material. Accordingly, a large change in the shape and volume of the bonding material due to melting can be prevented. As will be described later, sintering refers to a phenomenon: fine particles, in contact with each other, begin to bond together when the ambient temperature rises to a certain temperature; and the proportion of the bonding portion to the total mass increases with time and the bonded particles finally become an integrated continuous solid. In the case of sintering, a bonding portion as a whole does not melt and liquefy, and bonding progresses while the bonding portion remains solid macroscopically, thus without a large change in the shape and volume.

The sintered metal portion may be obtained, for example, by allowing a bonding material to be present between and in contact with the members, said bonding material containing as a main bonding material composite metallic nano-particles having such a structure that a metal core of a metal particle is combined and coated with an organic material, and heating or firing the bonding material while holding the bonding material at a predetermined position to bond the members together.

Preferably, the sintered metal portion is formed in the bonding portion between a semiconductor bare chip and a substrate, or the bonding portion between a semiconductor package and a wiring substrate.

Also disclosed is a metallizing apparatus for heating or firing a bonding material comprising a dispersion in a solvent of composite metallic nano-particles having such a structure that a metal core of a metal particle is combined and coated with an organic material to decompose and evaporate the organic material and sinter the metal particles, thereby metallizing the bonding material, comprising an inertial force energy application device for applying an inertial force energy to the bonding material.

By the provision of the inertial force energy application device to apply an inertial force energy, such as a shaking, vibrational or impact energy, to the bonding material, it becomes possible to promote release of the decomposed and evaporated organic material from the bonding portion. Ultrasonic waves may be employed for application of the vibrational energy. It is considered that the organic material which is combined with and covers the metal cores, during the heating and temperature rise, changes from the solid state to the semisolid or liquid state, then evaporates and thermally decomposes as usual, and finally becomes water vapor and carbon dioxide. The application of inertial force energy can facilitate release of a gas evaporated from the semisolid or liquid organic material being heated or a gas generated by decomposition of the organic material, thereby perfecting removal of the organicmaterial and enabling a complete metallization by the subsequent sintering.

Preferably, the inertial force energy application device is comprised of at least one of a device for applying a shaking energy to the bonding material, a device for applying a vibrational energy to the bonding material and a device for applying an impact energy to the bonding material.

Also disclosed is another metallizing apparatus for heating or firing a bonding material comprising a dispersion in a solvent of composite metallic nano-particles having such a structure that a metal core of a metal particle is combined and coated with an organic material to decompose and evaporate the organic material and sinter the metal particles, thereby metallizing the bonding material, comprising: a hermetically closable chamber for housing the bonding material therein; and a deaerating device for deaerating the interior of the chamber.

By housing the bonding material in the chamber, and deaerating the interior of the chamber to keep the chamber in a depressurized or vacuum condition during the heating of the bonding material, it becomes possible to considerably accelerate release of the gas (organic material) from the bonding portion.

### Brief Description of Drawings

FIG. 1 is a schematic diagram illustrating composite metallic nano-particles for use in the present invention, having such a structure that a metal core is combined and coated with an organic material;
FIG. 2 is a flow chart showing a known process for the production of composite silver nano-particles;
FIGS. 3A through 3D are diagrams illustrating, in sequence of process steps, a bonding method according to an embodiment of the present invention;
FIG. 4 is a graph showing the relationship between the particle size of Au nano-particles and the melting initiation temperature;
FIGS. 5A and 5B are cross-sectional diagrams illustrating, in sequence of process steps, a process of bonding a semiconductor package to a wiring substrate according to the present invention;
FIG. 6 is a flow chart showing a process of bonding a semiconductor package to a wiring substrate according to the present invention;
FIG. 7 is an enlarged cross-sectional diagram illustrating an example of a bonding portion between a wiring substrate and a bump of a semiconductor package;
FIG. 8 is a cross-sectional diagram illustrating an example of a semiconductor device mounted by a stepwise bonding process according to the present invention;
FIG. 9 is a flow chart showing a process of bonding members according to the present invention;
FIG. 10 is an electron micrograph showing the sate of a bonding material as applied onto a bonding object;
FIG. 11 is an electron micrograph showing the state of a silver layer as formed on the surface of a substrate having a fine groove, using a bonding material containing composite silver nano-particles as a main bonding material;
FIG. 12 is schematic diagram illustrating a bonded structure according to the present invention;
FIG. 13A is a conceptual diagram illustrating the process of bonding by sintering between small particles;
FIG. 13B is a conceptual diagram illustrating the process of bonding by sintering between a small particle and a large object;
FIG. 14A is a schematic diagram illustrating a metal structure in the course of sintering;
FIG. 14B is a schematic diagram illustrating the metal structure of a bonding portion after completion of bonding;
FIG. 15 is a schematic view of a metallizing apparatus according to an embodiment of the present invention;
FIG. 16 is a graph showing the relationship between shear bonding strength and firing time as observed for bonded copper plates which have been bonded in a lamination manner by the metallizing apparatus shown in FIG. 15, using a bonding material containing composite silver nano-particles as a main bonding material and silver material as an aggregate;
FIG. 17 is a flow chart illustrating a process example in a successive semiconductor package mounting system incorporating a metallizing apparatus;
FIG. 18A is an electron micrograph showing the state of a silver layer which has been embedded in a 0.4 µm-width trench formed in a Si substrate by metallizing a bonding material containing composite silver nano-particles by a metallizing apparatus;
FIG. 18B is an electron micrograph showing the state of a silver layer which has been embedded in a 0.15 µm-width trench formed in a Si substrate by metallizing a bonding material containing composite silver nano-particles by a metallizing apparatus;
FIG. 19 is a diagram illustrating a flattening phenomenon of a solder ball upon melting/liquefaction of the solder ball as observed in conventional soldering;
FIG. 20A is a diagram illustrating a solder twisting phenomenon of a solder ball as observed in conventional soldering;
FIG. 20B is a diagram illustrating a solder falling phenomenon of a solder ball as observed in conventional soldering;
FIG. 21A through 21E are diagrams illustrating, in sequence of process steps, a conventional bonding process for electrical contact;
FIG. 22 is a diagram illustrating another conventional bonding process for electrical contact; and
FIG. 23 is a diagram illustrating a conventional stepwise soldering.

### Best Mode for Carrying Out the Invention

Preferred embodiments of the present invention will now be described in detail with reference to the accompanying drawings.

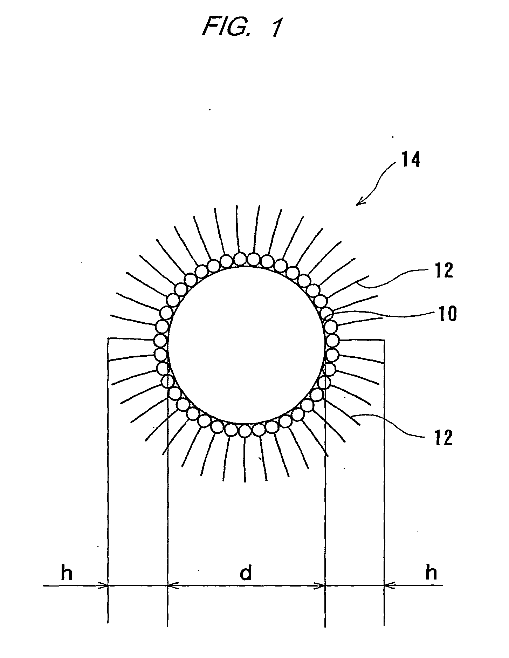

According to the bonding material of the present invention, as shown in FIG. 1, composite metallic nano-particles 14, each comprising a metal core 10 substantially composed of a metal component and a combining/coating layer (organic material layer) 12 composed of an organic material comprising as a main component C and H and/or O, are prepared. Since the metal core 10 is covered with the combining/coating layer 12 composed of the organic material, the composite metallic nano-particles 14 are stable, and have a low tendency to agglomerate in a solvent.

Each composite metallic nano-particle 14 is composed of the organic material and the metal component which is derived from a metal salt as a starting material, e.g., a carbonate, a formate or an acetate. The center portion of the composite metallic nano-particle 14 is comprised of the metal component, which is surrounded by the combining organic material. The organic material and the metal component are combined integrally, with part or all of thembeing chemically bonded together. Unlike conventional nano-particles which are stabilized by coating with a surfactant, the composite metallic nano-particles 14 have high stability, and are stable even at a higher metal concentration.

The average particle diameter d of the metal core 10 of the composite metallic nano-particle 14 is generally not more than 100 nm, preferably not more than 20 nm, more preferably not more than 10 nm, most preferably not more than 5 nm. The height h of the combining/coating layer 12 is, for example, about 1.5 nm. The minimum of the average particle diameter d of the metal core 10 may be any smallest possible one and is not particularly limited; however, the minimum is generally about 0.5 nm, preferably about 1.0 nm. By using such a particle size, it becomes possible to melt the metal core 10 at a considerably lower temperature than the melting point of the metal of the metal core 10, enabling a low temperature sintering. For example, in the case of clustered silver nano-particles having a size of about 5 nm, the sintering (melt-bonding) initiation temperature is about 210°C, and the silver nano-particles can be sintered and melt-bonded by heating the silver nano-particles at a temperature equal to or higher than the melting initiation temperature.

The composite metallic nano-particles 14 can be produced, for example, by heating a metal salt, such as a carbonate, formate or acetate, in a nonaqueous solvent and in the presence of a combining organic material, at a temperature not lower than the decomposition reduction temperature of the metal salt, but lower than the decomposition temperature of the combining organic material. As the metal component, Ag, Au or Pd, for example, may be used. As the combining organic material, a fatty acid with 5 or more carbon atoms or a higher alcohol with 8 or more carbons, for example, may be used.

The heating temperature is not lower than the decomposition reduction temperature of the metal salt such as a carbonate, formate or acetate, but lower than the decomposition temperature of the combining organic material. In the case of silver acetate, for example, the decomposition reduction temperature is 200°C. Thus, silver acetate may be held at a temperature that is not lower than 200°C, and at which the combining organic material is not decomposed. In this case, in order to make the combining organic material difficult to decompose, the heating atmosphere is preferably an inert gas atmosphere. By selecting a nonaqueous solvent, however, heating can be carried out even in the air.

Upon heating, an alcohol can be added, thereby promoting the reaction. The alcohol is not particularly limited insofar as it produces the reaction promoting effect. Specific examples of the alcohol include lauryl alcohol, glycerin, and ethylene glycol. The amount of the alcohol can be determined, as desired, depending on the type of the alcohol, etc. Usually, the alcohol maybe added in an amount of about 5 to 20 parts by weight, preferably 5 to 10 parts by weight, for 100 parts by weight of the metal salt.

After completion of the heating, purification is carried out by a known purification method. The purification method may, for example, be centrifugation, membrane purification, or solvent extraction.

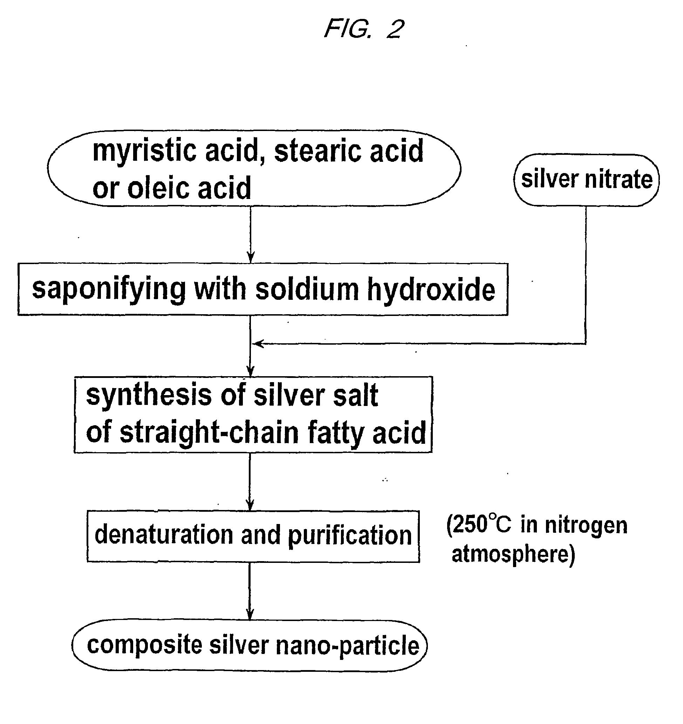

Composite silver nano-particles (composite metallic nano-particles) 14 having such a structure that a metal core (silver particle) 10 of ultrafine clustered silver as a simple substance, having a size of e.g. about 5 nm, is combined and coated with an organic material, e.g. an alkyl chain shell (combining/coating layer) 12, can be produced at a low cost, for example by saponifying myristic acid, stearic acid or oleic acid with sodium hydroxide, followed by reaction with silver nitrate to prepare a silver salt of straight-chain fatty acid (number of carbons of the alkyl chain is e.g. 14 or 18), and heating the salt at about 250°C for 4 hours in a nitrogen atmosphere, followed by purification, as illustrated in FIG. 2.

Further, though not shown diagrammatically, another production method comprises heating silver nitrate (metal salt) in a naphthenic high boiling solvent (nonaqueous solvent) and in the presence of oleic acid (ionic organic material) at about 240°C, which is not lower than the decomposition reduction temperature of silver nitrate and lower than the decomposition temperature of the ionic organic material, for 3 hours to produce composite silver nano-particles combined and coated with the ionic organic material.

The composite metallic nano-particles 14 are dispersed in an organic solvent, such as toluene, xylene, hexane, octane, decane, cyclohexane, pinene, limonene or ethylene glycol to prepare a bonding material. The composite metallic nano-particles 14 having such a structure that the surface of the metal core 10 is coated with the combining/coating layer (organic material layer) 12 of organic material, because of the organic material layer 12 functioning as a protective coating for protection of the metal core 10, can be dispersed stably in the solvent, and are highly stable as discrete particles. Accordingly, a liquid bonding material, in which the main bonding material (composite metallic nano-particles 14) that can be sintered and melt-bonded at a low temperature is uniformly dispersed, can be obtained.

By dispersing the composite metallic nano-particles 14 in an organic solvent such that the weight ratio of the metal portion to the total liquid is preferably within the range of 1 to 85% and adding, according to necessity, a dispersing agent or a gelling agent to the dispersion, a liquid bonding material having a desired fluidity upon heating, in which the main bonding material (composite metallic nano-particles 14) that can be sintered and melt-bonded at a low temperature is uniformly dispersed, can be obtained. If the weight ratio of the metal portion of the composite metallic nano-particles 14 to the total liquid exceeds 85%, the fluidity of the liquid bonding material significantly lowers. When filling a minute space with such a liquid bonding material, an incomplete filling is likely to occur.

If the weight ratio of the metal portion of the composite metallic nano-particles 14 to the total liquid is lower than 1%, due to the too much organic component content in the bonding material, degassing upon sintering is likely to be insufficient, causing defects in the bonding layer.

By dispersing the composite metallic nano-particles 14 in an organic solvent such that the weight ratio of the metal portion to the total fluid is preferably within the range of 15 to 90% and adding, according to necessity, a dispersing agent or a gelling agent to the dispersion, and making the dispersion into the form of a slurry, paste or cream, a bonding material in the form of a slurry, paste or cream having a desired fluidity upon heating, in which the main bonding material (composite metallic nano-particles 14) that can be sintered and melt-bonded at a low temperature is uniformly dispersed, can be obtained.

By dispersing the composite metallic nano-particles 14 in an organic solvent such that the weight ratio of the metal portion to the total bonding material is preferably within the range of 20 to 95% and adding, according to necessity, a dispersing agent or a gelling agent to the dispersion, and either solidifying the dispersion into a variety of shapes, e.g. a bar, a string or a ball, or semi-solidifying the dispersion into a jellylike form, a solid or semisolid bonding material having a desired fluidity upon heating, in which the main bonding material (composite metallic nano-particles 14) that can be sintered and melt-bonded at a low temperature is uniformly dispersed, can be obtained.

According to necessity, it is possible to add to the bonding material and disperse uniformly therein an aggregate, such as a metal material, a plastic material, or an inorganic material other than metal and plastic materials, either alone or in a combination thereof, generally having a particle size of 0.1 to 10 µm, preferably 0.1 to 1.0 µm. The addition of such an aggregate can impart various properties, which are absent when the composite metallic nano-particles alone are used, to the bonding material.

A metal material, e.g. Al, Cu, Mg, Fe, Ni, Au, Ag, Pd or Pt, may be used as the aggregate. The use as an aggregate of such a metal material having excellent electric conductivity secures a stable electric conductivity of the bonding material.

The upper limits of the contents of such an aggregate in various forms of bonding materials are shown in the previously-described Table 1. When the content of the aggregate exceeds the respective upper limits, the fluidity of the bonding material upon heating significantly lowers. When filling a minute space with such a liquid bonding material having a low fluidity, an incomplete filling is likely to occur. By making the volumetric content of the aggregate in the total bonding material within the ranges specified in Table 1, it becomes possible to provide a bonding material having a desired fluidity in which the main bonding material (composite metallic nano-particles) that can be sintered and melt-bonded at a low temperature and the aggregate are blended at a proper proportion.

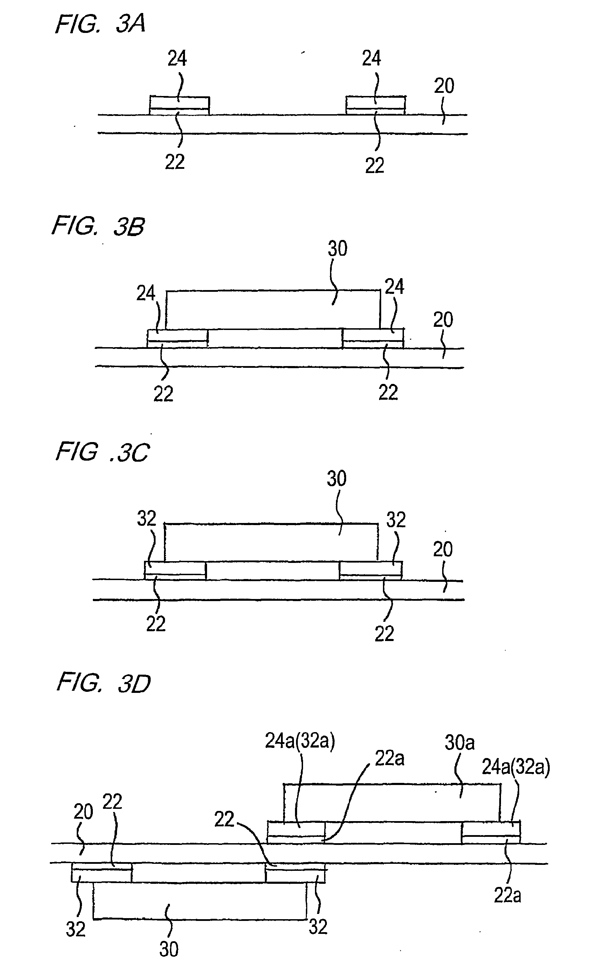

A description will now be given of a case of bonding a semiconductor device (semiconductor chip) to a ceramic circuit substrate by a face down bonding method using the above-described bonding material, by referring to FIGS. 3A through 3D. As the composite metallic nano-particles 14 are used herein composite silver nano-particles having metal cores 10 of clustered silver nano-particles having a size of 5 nm.

First, as shown in FIG. 3A, a bonding material, e.g. in a paste form, is applied (printed) onto predetermined portions of terminal electrodes 22 of a ceramic circuit substrate 20 to form composite metal bumps 24 having a height of about 2 µm and composed mainly of the composite metallic nano-particles 14.

Such a composite metal bump 24, because of the fineness of the dispersed composite metallic nano-particles 14, is almost transparent when the composite metallic nano-particles 14 are dispersed in a solvent. The physical properties of the bonding material, such as surface tension and viscosity, can be adjusted by selecting the type of the solvent, the concentration of the composite metallic nano-particles, the temperature, etc.

Next, as shown in FIG. 3B, using a face down method in which a semiconductor device 30 is held with its front surface facing downward, positioning of the electrode pad portions of the semiconductor device 30 with respect to the composite metal bumps 24 is carried out, thus in a so-called flip-chip manner, thereby bonding the electrode pad portions of the semiconductor device 30 to the composite metal bumps 24. Further, according to necessity, leveling may also be effected by the weight of the semiconductor device 30. It is of course also possible to employ a face up method.

In the case of composite silver nano-particles, low-temperature sintering is carried out in a hot-air oven at 210-250°C for about 30 minutes to thereby bond the electrode pad portions of the semiconductor device 30 to the terminal electrodes 22 of the circuit substrate 20 via a bonding layer 32 of silver, as shown in FIG. 3C. In particular, the solvent such as toluene contained in the composite metal bumps 24 is evaporated, and the composite metallic nano-particles 14, the main component of the composite metal bumps 24, are heated at a temperature at which the combining/coating layer (organic material layer) 12 (see FIG. 1) is released from the metal core (silver nano-particle) 10, or at a temperature which is equal to or higher than the decomposition temperature of the combining/coating layer 12 itself, thereby releasing the combining/coating layer 12 from the metal core 10 or decomposing the combining/coating layer 12 to evaporate it. The metal cores (silver nano-particles) 10 are thus brought into direct contact with one another and are sintered to form a silver layer, and the electrode pad portions of the semiconductor device 30 and the terminal electrodes 22 of the circuit substrate 20 are brought into direct contact with the silver layer, i. e. the bonding layer 32, and are bonded to the bonding layer 32. As a result, the electrode pad portions of the semiconductor device 30 and the terminal electrodes 22 of the circuit substrate 20 are bonded together via the bonding layer 32 of silver.

By thus bonding the semiconductor device to the circuit substrate through a low-temperature sintering e.g. at 210 to 250°C, a lead-free bonding, which can take the place of conventional solder bonding, can be effected.

Further, the melting temperature of the bonding portion is much higher than the bonding temperature, as described above. This offers the advantage that after the bonding, different parts can be bonded any number of times as desired at the same temperature or even at a high temperature.

In addition, as described above, by using a bonding material containing a metal material having a high electric conductivity as an aggregate, it becomes possible to secure a high electric conductivity of the bonding material and thereby enhance the reliability of semiconductor device mounting. When a bonding material containing a metal material is used, with the above-described change in the form of the composite metallic nano-particles, the composite metallic nano-particles are brought into direct contact with the surface of the aggregate (metal material) and are bonded to the aggregate. This also holds for a plastic material or an inorganic material such as a ceramic material.

When bonding a semiconductor device 30a also to the back surface of the ceramic circuit substrate 20, as shown in FIG. 3D, a bonding material, e.g. in a paste form, is applied onto predetermined portions of terminal electrodes 22a of the ceramic circuit substrate 20 to form composition metal bumps 24a. Thereafter, low-temperature sintering is carried out e.g. at 200 to 250°C, in particular at 210 to 250°C when composite silver nano-particles are employed, for about 30 minutes in a hot-air oven, thereby bonding the electrode pad portions of the semiconductor device 30a to the terminal electrodes 22a of the circuit substrate 20 via the bonding layer 32a of silver.

At the time of the later bonding of the semiconductor device 30a, the properties of the previously-formed bonding layer 32 of silver, in which the composite metallic nano-particles have changed their forms upon sintering, have turned to the same properties as the metal in a bulk state. In particular, the bonding layer 32 has the same melting point as the bulk metal, i. e. 961.93°C. Once the metal particles are bonded together or sintered, the bonding layer 32 does not melt unless it is heated to 961.93°C or higher. Accordingly, the bonding layer 32 does not melt upon the heating at the time of bonding of the semiconductor device 30a to the back surface of the ceramic circuit substrate 20. The bonding material thus offers an ideal bonding material for repeated bondings required of high-temperature soldering.

The bonding material in a paste form may be applied not only by simple coating, but also by other method such as spraying, brushing, dipping, spin coating, dispensing, screen printing, or transfer printing.

The bonding method of this embodiment can basically effect bonding between parts of all types of materials, i.e. metals, plastics and inorganic materials such as ceramics, including parts of the same type of material and parts of different types of materials.

Though in this embodiment the application of energy to change the form of the composite metallic nano-particles contained in the bonding material is carried out by heating (low-temperature sintering) by means of a hot-air oven, the energy application may be carried out by any other method, such as local heating by an energetic beam, particle beam irradiation, passing of electricity between parts, induction heating or dielectric heating of parts, etc. The composite metallic nano-particles, upon change of the form by the energy application, are bonded to one another, to a metal material or other additive, and to various bonding objects through sintering and/or melting.

According to the bonding method of the present invention, the heating temperature is restricted to 400°C. The reason for the restriction of heating temperature upon bonding will now be described, by referring to FIG. 4 which illustrates the relationship between the particle size of noble metallic nano-particles, which are frequently used practically, and the melting initiation temperature.

As shown in FIG. 4, a drastic lowering of melt bonding initiation temperature appears when the particle size of Au nano-particles decreases to smaller than 10 nm. When the particle size is 2 nm, for example, the temperature is as low as 120°C. On the other hand, heating at a temperature over 400°C will incur a significant deterioration or damage of a semiconductor device or other electronic parts. In view of the above, the upper limit of heating temperature is determined to be 400°C.

The bonding may be carried out in the air, in a dry air, in an inert gas atmosphere, in vacuum or in an atmosphere with reduced mist. In particular, by carrying out bonding in a clean atmosphere, a bonding surface before bonding can be prevented from being contaminated with a mist, such as a mineral oil, fat and oil, a solvent, water, etc., scattering and floating in air.

In advance of the bonding, the bonding surfaces of the above-described parts may be subjected to a surface treatment, such as cleaning/degreasing with an organic solvent or pure water, ultrasonic cleaning, chemical etching, corona discharge treatment, flame treatment, plasma treatment, ultraviolet-ray irradiation, laser irradiation, ion beam etching, sputter etching, anodic oxidation, mechanical grinding, fluid grinding, and blasting.

By thus removing contaminants and foreign matter on the surfaces of the to-be-bonded members or changing the roughness of the surfaces in advance of the bonding step, it becomes possible to create a surface morphology suited for bonding.

As described hereinabove, the present invention provides a bonding material and a bonding method which do not use a lead and which can replace a high-temperature soldering.

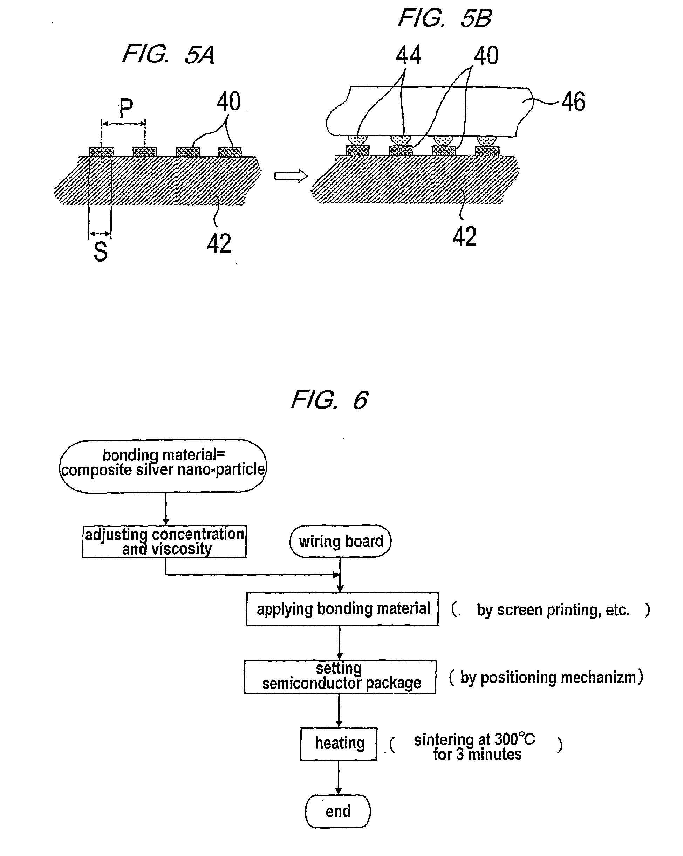

A process of bonding (surface mounting) a semiconductor package to a wiring substrate using the above-described bonding material will now be described with reference to FIGS. 5A, 5B and FIG. 6. In solder bonding, the following three types of bonding processes are generally practiced: (1) iron soldering; (2) flow soldering; and (3) reflow soldering (see "Story of Soldering", Japanese Standards Association, 2001, P. 65-74). The process of the present invention, on the other hand, basically comprises allowing a bonding material to be present between and in contact with necessary portions of bonding objects, and then heating and sintering the bonding material to effect bonding.

According to this embodiment, as the composite metallic nano-particles 14 shown in FIG. 1, composite silver nano-particles having metal cores 10 of clustered silver nano-particles having an average diameter d of 5 nm are employed. First, composite metallic nano-particles (composite silver nano-particles) 14 are dispersed in a solvent, such as hexane or toluene, and 30-300 nm silver particles as an aggregate are mixed with the dispersion to prepare a viscous creamy bonding material which can be fixed temporarily by printing.

Thereafter, as shown in FIG. 5A, the bonding material 40 is applied by screen printing, for example, onto predetermined portions (electrodes) of a wiring substrate 42. Next, as shown in FIG. 5B, a semiconductor package 46, having contact bumps (electrodes) 44 arranged in a lattice form on the back surface thereof, is positioned and set on the wiring substrate 42. The assembly is then heated to cause low-temperature sintering, thereby bonding and fixing the semiconductor package 46 to the wiring substrate 42. In particular, the solvent such as toluene contained in the bonding material 40 is evaporated, and the composite metallic nano-particles 14, the main component of the bonding material 40, are heated at a temperature at which the combining/coating layer (organic material layer) 12 is released from the metal core (silver nano-particle) 10, or at a temperature which is equal to or higher than the decomposition temperature of the combining/coating layer 12 itself, thereby releasing the combining/coating layer 12 from the metal core 10 or decomposing the combining/coating layer 12 to evaporate it. The metal cores (silver nano-particles) 10 are thus brought into direct contact with one another and are sintered to form a silver bonding layer, and the bumps 44 of the semiconductor package 46 and the electrodes of the wiring substrate 42 are brought into direct contact with the silver bonding layer, and are bonded to the silver bonding layer. As a result, the bumps 44 of the semiconductor package 4 6 and the electrodes of the wiring substrate 42 are bonded together via the silver bonding layer.

It has been confirmed that when a main bonding material comprising metal cores of silver nano-particles having an average particle diameter d of 5 nm is employed, a sufficient bonding can be effected under the heating conditions of 300°C and 3 minutes. By thus bonding the bumps 44 of the semiconductor package 46 to the electrodes of the wiring substrate 42 through low-temperature sintering e.g. at 300°C, a lead-free bonding, which can take the place of conventional solder bonding, can be effected.

It has been confirmed by experiments that when using a screen printing method, the spot size S of the bonding material 40 and the spot spacing P can be narrowed both to about 30 µm. Thus, as compared to the limit value 0.5 mm in the narrowing of solder balls in conventional BGA packages, less than one tenth of narrowing can be achieved. The bonding process of the present invention can thus realize a remarkably higher-density wiring, contributing large to high-density mounting of semiconductor devices.

Table 3 shows practically adoptable minimum values of spot spacings for electrodes, according to the present method and the conventional micro soldering.

**Table 3**

| Method | Object | Limit spot spacing |
|---|---|---|
| Micro soldering | QFP | 0.3 mm |
| | BGA/CSP/LGA | 0.5 mm |
| Present method | Ditto and High-power module, etc. | 30 µm |

As described above, according to the conventional micro soldering, the minimum limit value (limit spot spacing) of the lead spacing of GFP packages is 0.3 mm, and the limit value (limit spot spacing) of the solder ball pitch of BGA packages, including CSP packages and LGA packages, is 0.5 mm. According to the present invention, on the other hand, the limit value of the spot spacing of the bonding material can be narrowed to 30 µm.

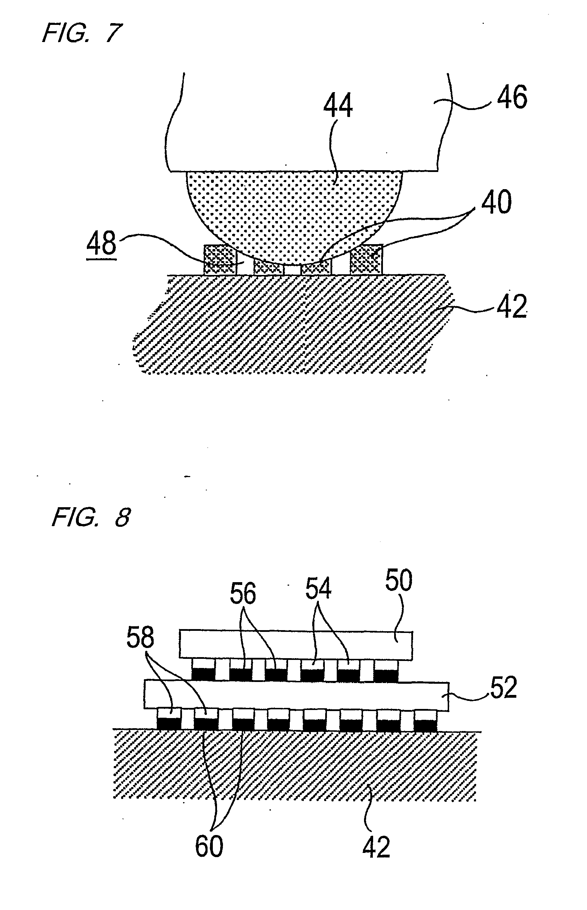

FIG. 7 shows an enlarged schematic view of the bump 44 of the semiconductor package 46 and the bonding portions of the wiring substrate 42. As shown in FIG. 7, it is possible to apply the bonding materials 40 onto the wiring substrate 42 in such a state that degassing grooves 48 are formed between the bonding materials 40, 40. This enables a gas evaporated from the organic solvent contained in the bonding material 40 and a gas generated by decomposition of the organic material that combines with and covers the metal cores to release easily. The provision of degassing grooves 48 thus improves the releasability of gases, and can therefore attain a lower-temperature and shorter-time sintering as compared to the case of not providing a degassing groove 48, which is very advantageous for practical operation.

FIG. 8 illustrates the state of a high-power module 50, a high-current density semiconductor device, when it is bonded and fixed to the wiring substrate 42 via an interposer 52. The high-power module 50 shown in FIG. 8, because of its interval high current density, can suffer from a large heat deformation due to its own heat generation and temperature rise. Insertion of the interposer 52 between the high-power module 50 and the wiring substrate 42 reduces thermal stress caused by a thermal expansion difference between the high-power module 50 and the wiring substrate 42, thereby avoiding damage to the parts by thermal shock and thermal fatigue.

According to this embodiment, as with the preceding embodiment, a bonding material is first applied, e.g. by screen printing, onto predetermined portions (electrodes) of the surface of the interposer 52. The high-power module 50, having contact bumps (electrodes) 54 arranged in a lattice form on the back surface thereof, is positioned and set on the interposer 52. Thereafter, low-temperature sintering of the bonding material is carried out, for example at 300°C for 3 minutes, thereby bonding the electrodes of the interposer 52 to the bumps 54 of the high-power module 50 via a bonding layer 56, thus mounting the high-power module 50 on the upper surface of the interposer 52. Next, the bonding material is applied, e.g. by screen printing, onto predetermined portions (electrodes) of the wiring substrate 42. The interposer 52, having contact bumps (electrodes) 58 arranged in a lattice form on the back surface thereof, is positioned and set on the wiring substrate 42. Thereafter, low-temperature sintering of the bonding material is carried out, for example at 300°C for 3 minutes, thereby bonding the electrodes of the wiring substrate 42 to the bumps 58 of the interposer 52 via a bonding layer 60, thus mounting the interposer 52 on the wiring substrate 42.

In the case where two-step solder bonding is required, as for the bonding between the high-power module 50 and the interposer 52, it has conventionally been forced to use a Sn(5%)-Pb(95%) high-temperature solder. Further, as described previously, there is no prospect of development of a lead-free high-temperature solder. Thus, attempts to find a bonding method that can comply with laws and regulations for environmental conservation have been deadlocked.

The method of the present invention, which makes it possible to use the same bonding material any number of times, can solve the above problem. Thus, at the time of the later bonding step, the properties of the previously-formedbonding layer 56 of silver or the like, in which the composite metallic nano-particles have changed their forms upon sintering, have turned to the same properties as the metal in a bulk state. In particular, the bonding layer 56 has the same melting point as the bulk metal, i.e. 961.93°C. Once the metal particles are sintered, the bonding layer 56 does not melt unless it is heated to 961.93°C or higher. Accordingly, the bonding layer 56 does not melt upon the heating in the second-step bonding. The bonding material thus offers an ideal bonding material for repeated bondings required of a high-temperature soldering.

As described herein above, the present invention can respond to the demand for higher integration and higher density, for example, in the semiconductor device mounting technology. Further, it becomes possible to carry out e.g. the first-step bonding of a stepwise bonding process with the use of the lead-free bonding material.

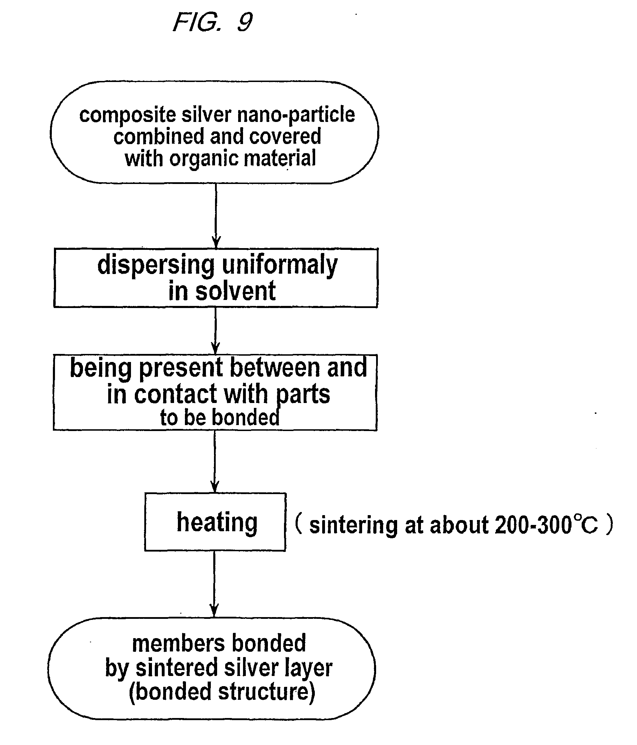

A process example for bonding members will now be described with reference to FIG. 9. In this example are used composite silver nano-particles (composite metallic nano-particles) 14 having such a structure that a metal core (silver nano-particle) 10 of ultrafine clustered silver as a simple substance, having a size of e.g. about 5 nm, is combined and coated with an organic material, e.g. an alkyl chain shell (combining/coating layer) 12, prepared in the above-described manner.

First, the composite silver nano-particles (composite metallic nano-particles) 14, each particle comprising the metal core 10 which is combined and coated with the combining/coating layer (alkyl chain shell) 12, are mixed and dispersed in a solvent comprising one or more of an organic solvent, a liquid polymer material, water and an alcohol, and, if necessary, a metal, plastic or inorganic material is added to and mixed with the dispersion to prepare a bonding material in a liquid or paste form.

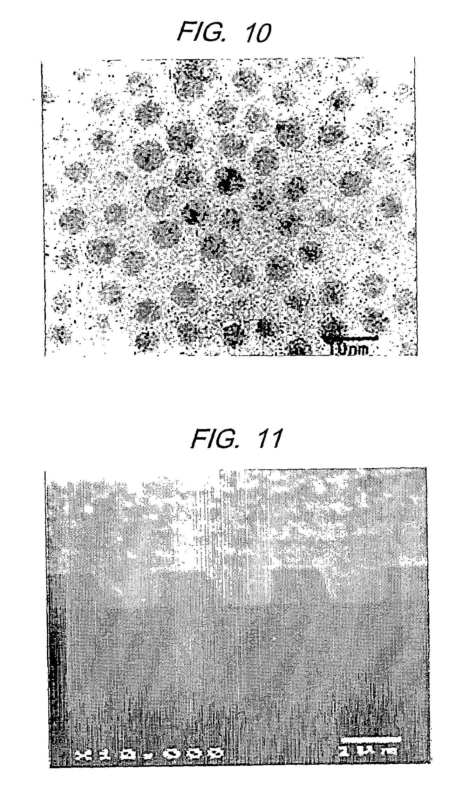

The bonding material is brought into contact with bonding portions of generally metallic members to be bonded, for example by coating, and is allowed to be present between the members. FIG. 10 shows the state of the bonding material as applied on the surface of a member. As can be seen from FIG. 10, the composite silver nano-particles are uniformly dispersed in the solvent while the respective particles are not in contact with one another.

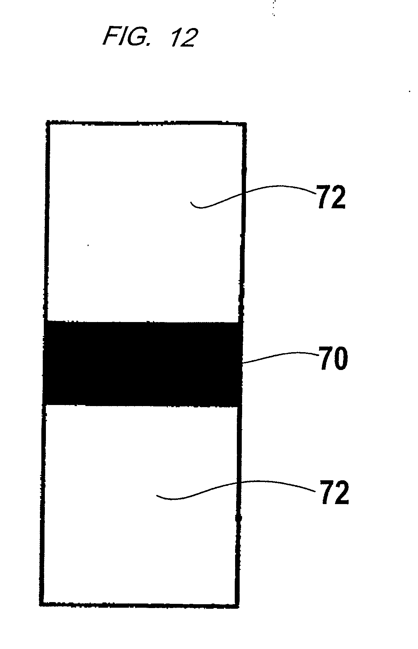

Thereafter, while the spacing between the bonding portions of the members is kept at a predetermined value or less, the bonding material is heated e.g. at 200-300°C to sinter the bonding material, thereby bonding the members 72 together via a bonding portion (sintered metal portion) 70 comprised of a silver layer of sintered structure, as shown in FIG. 12. In particular, it is known that the combining/coating layer (alkyl chain shell) 12 dissipates through the heat decomposition and evaporation by heating at about 200°C. Thus, when sintering the bonding material at 200 to 300°C, the combining/coating layer (alkyl chain shell) 12 surrounding the metal core 10 dissipates, while the metal cores 10 are brought into direct contact with one another and sintered to form the silver layer. Further, low-temperature sintering also occurs through direct contact between the silver layer and the respective surfaces of the members 72 to be bonded. As a result, the members 72 are bonded together via the bonding portion (sintered metal portion) 70.

It is considered that the silver nano-particles, through the low-temperature sintering phenomenon caused by the extreme fineness of the particles, are bonded together to form an integrated sintered structure of silver. Further, in general, a low-temperature sintering will also occur through contact between silver nano-particles and even a member of a metal other than silver, as with among the silver nano-particles, whereby bonding between the silver nano-particles and the bonding member will progress.

The composite silver nano-particles 14 used as a main bonding material, because of the coating of the core 10 with the combining/coating layer (alkyl chain shell) 12, are unlikely to agglomerate to become coarse particles before sintering in the bonding process of the members 72. Thus, during sintering, the silver nano-particles can enter into even a very fine space to effect a sufficient filling, enabling a reliable bonding.

FIG. 11 shows the state of a silver layer as formed in the above-described manner on the surface of a substrate having grooves whose width and depth are both about 1 µm. As apparent from FIG. 11, the fine grooves provided in the surface of the substrate are completely filled with the silver layer without formation of voids. Further, since the treatment temperature for bonding is as low as 200 to 300°C, unlike welding and high-temperature soldering, the bonding operation does not cause an excessive thermal deformation or distortion of the members 72. This is advantageous especially in the production of precision members or articles.

A description will now be made of the sintered structure formed by sintering. At the outset, sintering behavior, the essential mechanism of bonding, will be explained. FIG. 13A illustrates the process of bonding by sintering between small particles 80a and 80b, and FIG. 13B illustrates the process of bonding by sintering between a small particle 80 and a large object 82 (see "Metallurgy for a Million People", edited by S. Sakui, Agne, Sep. 1989, P. 272-277). Thus, in FIGS. 13A and 13B, the broken lines show the forms of the particles before sintering, and the solidlines show the forms of the particles after sintering.

It is considered that the bonding between silver nano-particles according to the present invention is fundamentally caused by migration of atoms and substances constituting the respective nano-particle, by surface diffusion and volumetric diffusion, toward the contact portion of the silver solids in contact with each other. As shown in FIG. 1, the metal cores 10 of the composite silver nano-particles 14 as a main bonding material are combined and coated with the combining/coating layer (alkyl chain shell) 12 of an organic material. The combining/coating layer (alkyl chain shell) 12 is decomposed and evaporated by heating and temperature rise, whereby the metal cores 10 come into direct contact with each other locally. Sintering starts from the contact portion, as shown in FIG. 13A. The power source that causes the sintering is surface tension inherent in the material that acts to decrease the surface area of the depressed portion at the contact portion between particles. This is true with the portion of the particle in contact with the bonding object, as shown in FIG. 13B.

The above-described behavior is considered to be the physical mechanism of sintering. The behavior tends to be rigorous as the particle is smaller. This is due to the fact that the surface tension, the driving force of material migration, is stored as a surface energy in the surface of a particle, and the total energy is proportional to the total sumof the respective surface areas of particles, and that the smaller each particle is, the larger is the total surface area, that is, the larger is the total surface energy stored in the surfaces of all particles (see "Metallurgy for a Million People", edited by S. Sakui, Agne, Sep. 1989, P. 277).

Accordingly, sintering occurs very easily with extremely fine particles. Thus, sintering occurs at a much lower temperature as compared to a normal material (low-temperature sintering).

As a result of the sintering phenomenon described above, the bonding portion 70 shown in FIG. 12 has a sintered metal structure. This represents a clear distinction from a so-called fusion bonding, such as welding and brazing, according to which a bonding portion is once fused locally, and is solidified by cooling immediately thereafter, thereby completing bonding. Thus, a solidified structure is necessarily present in the portion that has undergone welding or brazing, whereas such a structure is not present in the bonding portion according to the present invention. In the bonding portion according to the present invention, there are formed vacant lattice points and voids between crystal grains, which are characteristic of sintered structures. In addition, the crystal grain size tends to be smaller as compared to a bulk material.

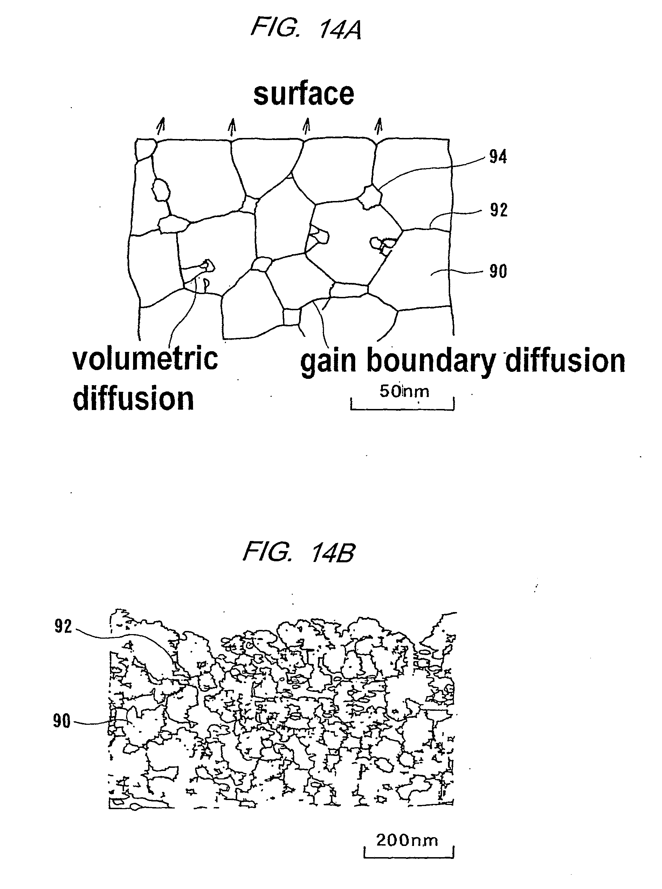

FIG. 14A illustrates a metal structure in the course of sintering process, in which the size of crystal grains 90 is about 50 nm, and voids 94, characteristic of a sintered body, are present at crystal grain boundaries 92 and in the crystal grains 90. As a result of vigorous diffusion of atoms, the voids 94 at the crystal grain boundaries 92 diminish with the progress of sintering and almost disappear. The voids 94 in the crystal grains 90 also diminish after an elapse of a long period of time (see "Metallurgy for a Million People", edited by S. Sakui, Agne, Sep. 1989, P. 278).

FIG. 14B shows the metal structure of a bonding portion which is obtained by bonding 0.3 mm - thick copper plates using the above-described composite silver nano-particles as a main bonding material such that the bonding portion has a thickness of about 20 µm. As with FIG. 14A, it can be seen from FIG. 14B that voids, which are inevitably formed during sintering, are present in crystal grains 90 and at crystal grain boundaries 92.

When using the above-described composite silver nano-particles as a main bonding material, the optimum temperature for carrying out the bonding according to the present invention has proven to be 210 to 300°C. Further, it has been confirmed by experiments that when the bonding is carried out e.g. at 300°C for 3 minutes, the crystal grains grow to a size of 5 to 200 nm, and that the bonding portion having a sintered structure has industrially sufficient mechanical and electrical properties.

As described hereinabove, according to the present invention, a bonding portion with industrially sufficient performance, which has a sintered metal structure and hence can meet various mechanical and electrical property requirements, can be obtained by a low-temperature process. Thus, unlike a bonding portion having a fused/solidified structure formed by fusion bonding using a solder or a brazing material, the bonding portion of the present invention can avoid problems, such as re-melting and thermal deformation, in a stepwise bonding process.

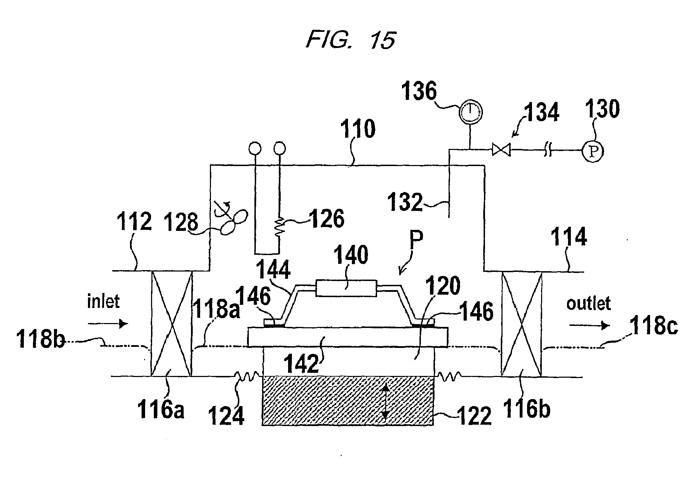

FIG. 15 shows a metallizing apparatus according to an embodiment of the present invention. The metallizing apparatus includes a hermetically closable chamber 110, to which an inlet passage 112 and an outlet passage 114 are connected openably/closably via gate valves 116a, 116b. Conveyors 118a, 118b, 118c are disposed linearly in the chamber 110, the inlet passage 112 and the outlet passage 114.

In the chamber 110, a holder 120 for placing thereon and holding a treating object P is disposed on the traveling route of the conveyor 118a. The holder 120 is vertically movable, and is coupled to the upper end of a vertically movable vibrating device 122 as an inertial force energy-application device. The vibrating device 122 is hermetically sealed with a flexible seal 124. On the ceiling side in the chamber 110, a heater 126 and a fan 128 are provided, disposed close to each other, so that a hot air can be blown toward to the treating object P placed and held on the holder 120. Further, a vacuum pipe 132, extending from a vacuum pump 130, is connected to the chamber 110. The vacuumpipe 132 and vacuum pump 134 constitute a deaerating device 134 for keeping the chamber 110 in a depressurized or vacuum condition. The vacuum pipe 132 is provided with a pressure gauge 136 for measuring the pressure in the chamber 110.

The metallizing apparatus is for heating and firing a bondingmaterial comprising a dispersion in a solvent of composite metallic nano-particles, which have been produced by combining and coating metallic nano-particles as metal cores with an organic material, to decompose and evaporate the organic material and sinter the metallic nano-particles, thereby metallizing the bonding material.

Described hereinbelow is a case where the treating object P is comprised of a semiconductor device 140, e.g. a QFP (Quad Flat Package) commonly employed as a semiconductor package and a wiring substrate 142, and a bonding material 146 is allowed to be present between the leads 144 of the semiconductor device 140 and the electrodes of the wiring substrate 142, and the bonding material 146 is metallized, thereby mounting the semiconductor device 140 on the wiring substrate 142.

At the outset, a description will be given of the process of bonding (surface mounting) the semiconductor device 140 to the wiring substrate 142 using a bonding material comprising, as the composite metallic nano-particles 14 (see FIG. 1), composite silver nano-particles having metal cores 10 of clustered silver nano-particles having an average diameter d of 5 nm. First,the composite metallic nano-particles (composite silver nano-particles) 14 are dispersed in a solvent, such as hexane or toluene, and 30-300 nm silver particles as an aggregate are mixed with the dispersion to prepare a creamy bonding material 146 having a sufficient viscosity to be fixed temporarily by printing.

Thereafter, the bonding material 146 is applied by screen printing, for example, onto predetermined portions (electrodes) of the wiring substrate 142. The semiconductor device 140 having the leads 144 is positioned and set on the wiring substrate 142. The assembly is then heated to cause low-temperature sintering, thereby bonding and fixing the semiconductor device 140 to the wiring substrate 142. In particular, the solvent such as toluene contained in the bonding material 146 is evaporated, and the composite metallic nano-particles 14, the main component of the bonding material 146, are heated at a temperature at which the combining/coating layer (organic material layer) 12 is released from the metal core (silver nano-particle) 10, or at a temperature which is equal to or higher than the decomposition temperature of the combining/coating layer 12 itself, thereby releasing the combining/coating layer 12 from the metal core 10 or decomposing the combining/coating layer 12 to evaporate it. The metal cores (silver nano-particles) 10 are thus brought into direct contact with one another and are sintered to form a silver layer, and the leads 144 of the semiconductor device 140 and the electrodes of the wiring substrate 142 are brought into direct contact with the silver layer as a bonding layer, and are bonded to the bonding layer of silver. As a result, the leads 144 of the semiconductor device 140 and the electrodes of the wiring substrate 142 are bonded together via the bonding layer of silver.

It has been confirmed that when a main bonding material comprising metal cores of silver nano-particles having an average particle diameter d of 5 nm is employed, a sufficient bonding can be effected under the heating conditions of 300°C and within 3 minutes. By thus bonding the leads 144 of the semiconductor device 140 to the electrodes of the wiring substrate 142 through a low-temperature sintering e.g. at about 300°C, a lead-free bonding, which can replace conventional solder bonding, can be effected.

Next, the metallizing treatment by the use of the metallizing apparatus shown in FIG. 15 will be described.

First, the treating object P comprising the semiconductor device 140 and the wiring substrate 142 is loaded onto the conveyor 118b in the inlet passage 112, and the conveyors 118a, 118b are allowed to travel, while the gate valve 116 is open, to convey the heating object P onto the holder 120, and then the gate valve 116a is closed. By continuous operating the heater 126 and the fan 128, a hot air is blown toward the treating object P on the holder 120 so as to heat the entirety of treating object P, including the bonding material 146, at a predetermined temperature. During the heating, the vacuum pump 130 is actuated to keep the chamber 110 in a depressurized or vacuum condition, while the vibrating device 122 is actuated to impart an inertial force energy to the entirety of treating object P including the bonding material 146.

A vaporized gas generated from the organic material which has been liquefied by the temperature rise and a gas generated by decomposition of the organic material, with the aid of the vacuum evacuation and the vibrational energy, break the ambient binding and leave actively, and are attracted and evacuated, through the space in the chamber 110, into the vacuum pump 130. As a result, the decomposition and vaporization of the organic material become more active. By the actuation of the vacuum pump 130, the pressure in the chamber 110 is kept at an appropriate value lower than atmospheric pressure (760 Torr) but over 1 ×10⁻³ Torr, whereby the release of gasses is promoted.

Further, the application of an appropriate vibrational energy (frequency and amplitude) accelerates material migration within the organic material in a semi-molten or liquid state, which also promotes the release of the organic material.

After carrying out the metallizing treatment for a predetermined length of time, the actuations of the vacuum pump 130 and the vibrating device 122 are stopped, and the gate valve 116b is opened. Thereafter, the conveyors 118a, 118c are allowed to travel to convey the treating object P after the treatment to the next process step.

Though in this embodiment the vibrating device 122 as an inertial force energy-application device and the deaerating device 134 are provided, it is possible to provide only one of them. The degassing promoting effect can be obtained to a certain extent even in such a case. Further, instead of the vibrating device 122, it is possible to use, as an inertial force energy-application device, a device for applying a shaking energy to the bonding material or a device for applying an impact energy to the bonding material. Such inertial force energy-application devices may be used plurally in combination.

The bonding operation by the metallizing apparatus using composite metallic nano-particles as a main bonding material makes it possible to carry out, for example, (1) mounting of a bare semiconductor chip to an interposer or the like, and (2) mounting of a semiconductor package to a wiring substrate. This breaks the conventional restraint of being forced to use a solder material containing a high concentration of Pb.

Further, besides a semiconductor product, also for a brazing structure in general (heat exchanger, aircraft part, etc.) with which a high-temperature brazing material is commonly used for its bonding, bonding can be effected at a much lower temperature by using the metallizing apparatus of this embodiment. Accordingly, the bonded part or structure is free from such problems as thermal deformation, thermal distortion and thermal stress, which occur frequently at high temperatures. Furthermore, the bonded part or structure has the advantage that once the bonding by low-temperature sintering is completed, melting of the bonding portion does not occur unless it is heated to the melting point of the metal used in the bonding material.

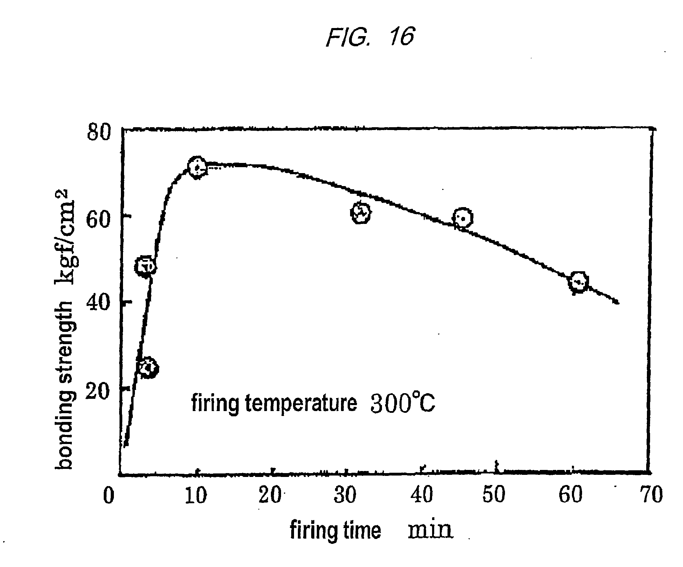

FIG. 16 shows the relationship between shear bonding strength and firing time, as experimentally determined for bonded copper plates which have been bonded in a lamination manner by the metallizing apparatus shown in FIG. 15, using a bonding material comprising composite silver nano-particles as a main bonding material and silver material as an aggregate.

As can be seen from FIG. 16, the maximum bonding strength of 71 Kgf/cm² is obtained when sintering is carried out at 300°C for 10 minutes. Assuming now a necessary shear bonding strength value to be one-half of 150 Kgf/cm², which is the necessary tensile bonding strength value for a lead solder-bonded onto a conductive pad, as an index of bonding strength (see Sugishita, "Method for Evaluation of Thick Film Paste", The Nikkan Kogyo Shimbun, 1985, P. 54-55; and Fukuoka, "First Electronics Mounting Technology", Kogyo Chosakai Publishing, 2000, P. 89-91), the above bonding strength obtained by the sintering nearly comes up to the level of 75 Kgf/cm², the necessary shear bonding strength for a pull-up type soldering of a semiconductor device.

For bonding of e.g. a bear semiconductor chip to an interposer or the like, in place of the conventional micro soldering technique, room-temperature pressure bonding has recently been employed frequently especially for the production of a small-size thin wiring substrate. While the production of a small and thin wiring substrate becomes possible by the pressure bonding, a certain bonding load must be applied to a bear chip, which could cause damage, such as cracking or breaking, to an insulating layer within the chip. This problem is serious especially with a recent highly-integratedmulti-layer chip which employs a low-k material for an insulating layer, because the strength and the rigidity of a low-k material is considerably lower than those of conventional insulating materials.

In such an application, in place of the pressure contact, the metallizing treatment using the above-described metallizing apparatus can be carried out, which makes it possible to complete bonding solely by heating without a mechanical load application. Accordingly, an insulating layer, especially of a low-k material, can remain undamaged after the bonding. The metallizing treatment by the metallizing apparatus, when carried out in a mounting process, can thus respond to the demand for a smaller and thinner product.

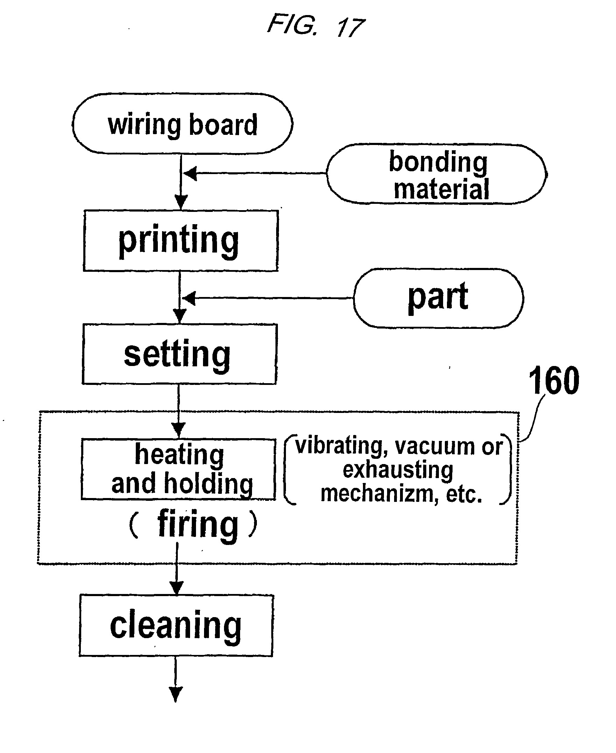

FIG. 17 shows a process example in a successive semiconductor package mountaining system incorporating the metallizing apparatus used in the present invention. The process comprises successive steps of: printing a bonding material onto a wiring substrate; setting a part, such as a semiconductor device, on the wiring substrate; conveying the assembly to a metallizing apparatus 160; carrying out the above-described metallizing treatment to mount the part (semiconductor device) to the wiring substrate in the metallizing apparatus 160; and cleaning the resulting wiring substrate.

Besides semiconductor device mounting, the above-described metallizing treatment using the metallizing apparatus can also be employed for the formation of interconnects of a semiconductor device, the production of a small part using a mold, etc.

The metallizing apparatus used in the present invention thus has a wide range of applications. Depending upon applications, the necessary thickness of the sintered metal body may vary widely from about 0.1 µm to its several tens of thousands times, i.e. several mm.

Accordingly, as a matter of course, the process of the present invention is not limited to the one shown in FIG. 17. It is of course possible to carry out the basic process: (1) supply of a bonding material; and (2) heating (firing) of the bonding material, any desired number of times, and change the operating conditions of the steps according to applications.

Further, in relation to the above background and also to the processing speed and volume, the metallizing apparatus itself can take various forms. Thus, in addition to an inline-type metallizing apparatus as shown in FIG. 15, a batch-type metallizing apparatus which carries out metallizations of a number of treating objects simultaneously, a clustered tool-type metallizing apparatus in which similar treatment chambers are arranged radially, or other types or forms of metallizing apparatuses may be employed.

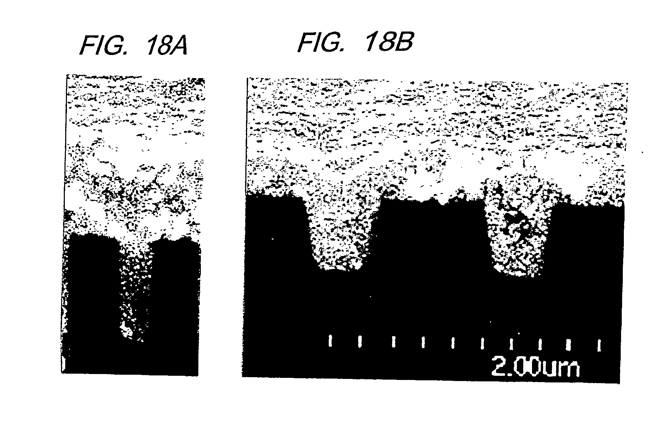

FIGS. 18A and 18B show the state of silver layers embedded in trenches, which have been embedded in a 0.15 µm - width trench (FIG. 18A) and in a 0.4 µm - width trench (FIG. 18B), both formed in a Si substrate, by metallizing a bonding material (filling material) containing composite silver nano-particles using the metallizing apparatus in the above-described manner. In embedding of a metal in a trench having a width of 0.15 µm or less by performing conventional plating, voids are often formed in the embedded metal. In contrast, FIGS. 18A and 18B show that the bottoms of the trenches are fully filled with silver metal, demonstrating an effective filling of fine trenches.

As described hereinabove, the metallization of the bonding material according to the present invention can easily and securely achieve bonding which can replace the conventional micro soldering and which, owing to no use of lead or tin, can eliminate environmental burden of heavy metal contamination.

### Industrial Applicability

The present invention relates to a bonding method which effects bonding between parts by using composite metallic nano-particles.

## Claims

1. A bonding method comprising:
allowing a bonding material to be present between and in contact with a first member and a second member to be bonded, said bonding material comprising a dispersion in an organic solvent of composite metallic nano-particles each having such a structure that a metal core of a metal particle having a diameter of 0.5 nm to 100 nm is combined and coated with an organic material;
heating the bonding material at a temperature which is equal to or higher than the decomposition initiating temperature of the organic material, but lower than the melting temperature of the metal in a bulk state so as to release the organic material from the metal core of the bonding material present between the first member and the second member and to sinter the metal core, thereby forming a bulk metal and bonding the first member and the second member together to obtain a bonded component;
allowing the same bonding material to be present between and in contact with the obtained bonded component and a third member; and then heating the same bonding material at a temperature which is equal to or higher than the decomposition initiating temperature of the organic material, but lower than the melting temperature of the metal in a bulk state so as to release the organic material from the metal core of the bonding material present between the bonded component and the third member and to sinter the metal core without melting said bulk metal, thereby bonding the bonded component and the third member.

2. The method of claim 1 wherein said dispersion is in a liquid form.

3. The method of claim 1 wherein said dispersion is in the form of a slurry, paste or cream.

4. The method of claim 1 wherein said dispersion is in a solid or jellylike form.

5. The method of any of the preceding claims wherein said bonding material comprises an aggregate having an average particle size of not more than 100 µm.

6. The method of claim 5 wherein the aggregate is of a metallic material, a plastic material or an inorganic material, or a combination thereof.

7. The method of claim 6 wherein the inorganic material comprises a ceramic material, carbon, diamond or a glass.

8. The method of any of the preceding claims wherein the metal core of the composite metallic nano-particles is composed of either one of Au, Ag, Pd, Pt, Cu, and Ni, or a combination of two or more thereof.

9. The method of any of the preceding claims wherein the bonding is carried out in air, dry air, an oxidizing gas atmosphere, an inert gas atmosphere, a vacuum, or in an atmosphere with reduced mist.

10. The method of any of the preceding claims, further comprising the step of subjecting a bonding surface of each of the first member, the second member, the obtained bonded component, and the third member to a surface treatment before said respective steps of allowing the bonding material to be in contact therewith.

## Patentansprüche

1. Ein Bindeverfahren, welches folgendes aufweist:
Erlauben, dass ein Bindematerial zwischen und in Kontakt mit einem ersten Glied und einem zweiten Glied, welche verbunden werden sollen, vorhanden ist, wobei das Bindematerial eine Dispersion in einem organischen Lösungsmittel aus kompositmetallischen Nanoteilchen beinhaltet, welche jeweils eine Struktur haben, dass ein Metallkern eines Metallpartikels einen Durchmesser von 0,5 nm - 100 nm kombiniert ist und mit einem organischen Material beschichtet ist;
Heizen des Bindematerials auf eine Temperatur, welche gleich oder größer ist als die Temperatur, bei welcher die Zersetzung des organischen Materials ausgelöst wird, aber niedriger als die Schmelztemperatur des Metalls in einem festen Zustand, so dass das organische Material von dem Metallkern des Bindematerials, welches zwischen dem ersten Glied und dem zweiten Glied vorhanden ist, abgelöst wird, und zum Sintern des Metallkerns, wobei ein festes Metall ausgebildet wird und das erste Glied und das zweite Glied zusammen verbunden werden, um eine verbundene Komponente zu erhalten;
Erlauben, dass das gleiche Bindematerial zwischen und in Kontakt mit der erhaltenen verbundenen Komponente und einem dritten Glied vorhanden ist; und dann Heizen des gleichen Bindematerials auf eine Temperatur, welche gleich ist oder höher als die Temperatur, bei welcher die Zersetzung des organischen Materials ausgelöst wird, aber niedriger als die Schmelztemperatur des Metalls in einem festen Zustand, um das organische Material von dem Metallkern des Bindematerials, welches zwischen der verbundenen Komponente und dem dritten Glied vorhanden ist, abzulösen, und um den Metallkern ohne Schmelzen des festen Materials zu sintern, wodurch die verbundene Komponente und das dritte Glied verbunden werden.

2. Ein Verfahren gemäß Anspruch 1, wobei die Dispersion in einer flüssigen Form ist.

3. Das Verfahren gemäß Anspruch 1, wobei die Dispersion in der Form einer Aufschlemmung, Paste oder Creme ist.

4. Das Verfahren gemäß Anspruch 1, wobei die Dispersion in einer festen oder gelähnlichen Form ist.

5. Das Verfahren gemäß einem der vorhergehenden Ansprüche, wobei das Bindematerial einen Zuschlagstoff beinhaltet, welcher eine durchschnittliche Partikelgröße von nicht mehr als 100 µm hat.

6. Das Verfahren gemäß Anspruch 5, wobei der Zuschlagstoff ein metallisches Material, ein Plastikmaterial oder ein anorganisches Material, oder eine Kombination davon ist.

7. Das Verfahren gemäß Anspruch 6, wobei das anorganische Material ein keramisches Material, Kohlenstoff, Diamant oder ein Glas aufweist.

8. Das Verfahren gemäß einem der vorhergehenden Ansprüche, wobei der Metallkern der kompositmetallischen Nanopartikel aus einem von Au, Ag, Pd, Pt, Cu, und Ni oder einer Kombination von zwei oder mehr davon besteht.

9. Das Verfahren gemäß einem der vorhergehenden Ansprüche, wobei das Binden in Luft, trockener Luft, einer Atmosphäre aus oxidierendem Gas, einer Inertgasatmosphäre, einem Vakuum oder in einer Atmosphäre mit verringerter Feuchtigkeit durchgeführt wird.

10. Das Verfahren gemäß einem der vorhergehenden Ansprüche, welches ferner die Schritte des Aussetzens einer Bindeoberfläche von jedem des ersten Glieds, des zweiten Glieds, der erhaltenen verbundenen Komponente, und des dritten Glieds zu einer Oberflächenbehandlung vor den jeweiligen Schritten des Erlaubens, dass das Bindematerial in Kontakt damit ist, aufweist.

## Revendications

1. Procédé de liaison comprenant :
permettre à un matériau de liaison d'être présent entre et d'être en contact avec un premier élément et un deuxième élément destinés à être liés, ledit matériau de liaison comprenant une dispersion dans un solvant organique de nanoparticules métalliques composites ayant chacune une structure telle qu'une âme métallique d'une particule métallique ayant un diamètre de 0,5 nm à 100 nm soit combinée et revêtue d'un matériau organique ;
chauffer le matériau de liaison à une température qui est égale ou supérieure à la température de début de décomposition du matériau organique, mais inférieure à la température de fusion du métal dans un état brut de manière à libérer le matériau organique de l'âme métallique du matériau de liaison présent entre le premier élément et le deuxième élément et à agglomérer l'âme métallique, en formant ainsi un métal brut et en liant le premier élément et le deuxième élément ensemble pour obtenir un composant lié ;
permettre audit matériau de liaison d'être présent entre et d'être en contact avec le composant lié obtenu et un troisième élément ; et ensuite
chauffer ledit matériau de liaison à une température qui est égale ou supérieure à la température de début de décomposition du matériau organique, mais inférieure à la température de fusion du métal dans un état brut de manière à libérer le matériau organique de l'âme métallique du matériau de liaison présent entre le composant lié et le troisième élément et à agglomérer l'âme métallique sans faire fondre ledit métal brut, en liant ainsi le composant lié et le troisième élément.

2. Procédé selon la revendication 1, dans lequel ladite dispersion est sous une forme liquide.

3. Procédé selon la revendication 1, dans lequel ladite dispersion est sous la forme d'une suspension, pâte ou crème.

4. Procédé selon la revendication 1, dans lequel ladite dispersion est sous une forme solide ou visqueuse.

5. Procédé selon l'une quelconque des revendications précédentes, dans lequel ledit matériau de soudage comprend un agrégat ayant une taille de particules moyenne non supérieure à 100 µm.

6. Procédé selon la revendication 5, dans lequel l'agrégat est composé d'un matériau métallique, un matériau plastique ou un matériau inorganique, ou une combinaison de ceux-ci.

7. Procédé selon la revendication 6, dans lequel le matériau inorganique comprend un matériau céramique, du carbone, du diamant ou du verre.

8. Procédé selon l'une quelconque des revendications précédentes, dans lequel l'âme métallique des nanoparticules métalliques composites est composée d'un des éléments parmi Au, Ag, Pd, Pt, Cu, et Ni, ou une combinaison de deux ou plusieurs de ceux-ci.

9. Procédé selon l'une quelconque des revendications précédentes, dans lequel la liaison est réalisé à l'air, à l'air sec, dans une atmosphère de gaz oxydant, une atmosphère de gaz inerte, sous vide, ou dans une atmosphère à humidité réduite.

10. Procédé selon l'une quelconque des revendications précédentes, comprenant en outre l'étape consistant à soumettre une surface de liaison de chacun parmi le premier élément, le deuxième élément, le composant lié obtenu, et le troisième élément à un traitement de surface avant lesdites étapes respectives consistant à mettre le matériau de liaison en contact avec eux.
